(19) **Europäisches Patentamt**
**European Patent Office**
**Office européen des brevets**

(11) **EP 3 605 815 B1**

(12) **EUROPEAN PATENT SPECIFICATION**

(45) Date of publication and mention
of the grant of the patent:
**19.05.2021 Bulletin 2021/20**

(51) Int Cl.:
*H02M 1/42* *(2007.01)* *G01R 21/06* *(2006.01)*
*G01R 21/133* *(2006.01)* *H02M 1/00* *(2006.01)*

(21) Application number: **19189622.4**

(22) Date of filing: **01.08.2019**

(54) **METHODS OF CALCULATING POWER INPUT AND ELECTRICAL POWER SYSTEMS UTILIZING SAME**

VERFAHREN ZUR BERECHNUNG DER EINGANGSLEISTUNG UND DIESE BENUTZENDE ELEKTRISCHE LEISTUNGSSYSTEME

PROCÉDÉ DE CALCUL DE L''ENTRÉE DE PUISSANCE ET SYSTÈMES D'ALIMENTATION ÉLECTRIQUE L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.08.2018 US 201816052328**

(43) Date of publication of application:
**05.02.2020 Bulletin 2020/06**

(73) Proprietor: **Osram Sylvania Inc.**
**Wilmington, MA 01887 (US)**

(72) Inventors:
• **JOHNSEN, Andrew O.**
**Sanbornton, New Hampshire 03269 (US)**

• **BEHJATI, Hamid**
**North Reading, Massachusetts 01864 (US)**

(74) Representative: **Viering, Jentschura & Partner mbB**
**Patent- und Rechtsanwälte**
**Am Brauhaus 8**
**01099 Dresden (DE)**

(56) References cited:
**CN-A- 101 764 528    US-A1- 2008 315 852**
**US-A1- 2010 246 220    US-A1- 2014 239 741**
**US-A1- 2016 190 912**

**Description**

The present disclosure generally relates to the field of electrical power and energy measurement and metering. In particular, the present disclosure is directed to methods of calculating power input into a power factor correction stage, and electrical power systems utilizing same.

A first conventional method calculates input power by determining the output power of an SSLD-driver unit and dividing it by the estimated efficiency of the unit. The output power of the unit is calculated using the direct current (DC) output voltages and currents. The efficiency estimation is based on a lookup table that is stored in flash memory of the microcontroller of the driver unit. Although simple, this method lacks high accuracy, because it uses a lookup table to estimate the efficiency of the unit.

A second method employs an additional power-metering integrated circuit (IC) and circuitry at the input of the unit. The power-metering IC samples the input alternating current (AC) voltage and current at very high frequency. The sampled input voltages and currents are then multiplied and averaged over a 60Hz mains cycle to determine the input power. This method offers high accuracy but increases the production cost of the manufacturer because it requires additional components and circuitry.

A third method assumes a unity power factor and a pure sinusoidal input current. The peak value of the input current is then used to estimate the root mean square (RMS) of the input current. The RMS input voltage is estimated in the same fashion. The input power is then calculated by multiplying the RMS input voltage and the RMS input current. Although this method does not require a high sampling rate, it is prone to high error percentage due to the several idealistic assumptions it is based on, namely, unity power factor and pure sinusoidal current.

US 2016/190912 A1 discloses a method of measuring an input power of a power factor converter (PFC), which includes monitoring a rectified voltage signal from an input of the PFC, determining a pulse timing value of the PFC, determining the input power by multiplying the monitored rectified voltage with the pulse timing value of the PFC to form multiplied values, and accumulating the multiplied samples.

US 2008/315852 A1 discloses a power factor controller that includes a voltage loop compensator producing a voltage compensation signal as a function of an output voltage of the power processing circuit.

CN 101 764 528 A discloses a high power factor DCM Boost PFC converter.

US 2010/246220 A1 discloses a power supply having a specified hold-up time to take an input voltage and convert it to an output voltage.

US 2014/239741 A1 discloses a method for controlling the temperature of a semiconductor device on an inverter of a drive configured to drive an electrical machine.

In one implementation, the present disclosure is directed to a method of measuring power input into a system that includes a power factor compensation (PFC) stage that includes a switch controlled by a switch controller. The method includes the features according to claim 1. Additional features for advantageous embodiments are recited in the dependent claims thereto.

In another implementation, the present disclosure is directed to a device. The device includes the features according to claim 8. Additional features for advantageous embodiments are recited in the dependent claims thereto.

The foregoing and other objects, features and advantages disclosed herein will be apparent from the following description of particular embodiments disclosed herein, as illustrated in the accompanying drawings in which like reference characters refer to the same parts throughout the different views. The drawings are not necessarily to scale, emphasis instead being placed upon illustrating the principles disclosed herein.

FIG. 1 is a high-level block diagram of salient aspects of an electrical-power system that includes an input-power estimator according to embodiments disclosed herein.

FIG. 2 is a high-level diagram of a scenario that includes a higher-level system that utilizes input-power data from a plurality of devices that each include an electrical-power system of FIG. 1.

FIG. 3 is a diagram illustrating the input current profile of a power-factor compensation (PFC) stage of a critical conduction mode boost-type PFC device.

FIG. 4 is a graph of $t_{on}$ versus $P_{in,driver}$ for three different values of $U_{in,rms}$ in a specific digitally addressable lighting interface (DALI) device.

FIG. 5 is a circuit diagram of an example front-end boost-type PFC stage according to embodiments disclosed herein.

FIG. 6 is a partial operational diagram/partial block diagram of a PFC switch controller and an input-power estimator according to embodiments disclosed herein.

FIG. 7 is a partial operational diagram/ partial block diagram of the PFC switch controller and the input-power estimator enhanced with a temperature compensator to compensate for the current operating temperature of a PFC stage that the PFC switch controller is controlling, according to embodiments disclosed herein.

In some aspects, the present disclosure is directed to an electrical-power system that includes a power factor compensation (PFC) stage and that uses an input-power-estimating equation that simplifies the determination of the amount of power being input into the PFC stage. As described below in detail in connection with an example critical conduction mode boost-type PFC stage, the input-power-estimating equation is based on a slope-intercept simplification of a quadratic equation that provides an exact solution for the input power as a function of various parameters of the PFC stage. As will be seen below, the simplification of an input-power-estimating equation of the present disclosure (hereinafter, "slope-intercept equation") can be implemented very efficiently within, for example, a microcontroller that may already be available to control the PFC stage. Implementation of such slope-intercept equation can provide accurate input-power-estimates suitable for any use, including, but not limited to, smart power management and smart metering. As will be seen below, an electrical-power system of the present disclosure can be used in any of many of a wide variety of commercial devices, including devices participating in the Internet of things (IoT). Those skilled in the art know that examples of such devices include, but are not limited to, industrial lighting drivers (e.g., drivers such as the OTi85 DALI, OTi60 DALI, OTi50 DALI, and OTi30 DALI available from OSRAM), household appliances with front-end PFC stage (such as smart LCD/LED TVs, laptop chargers, and cell-phone charges), among many others. Fundamentally, the types of electrical-power systems in which aspects of the present disclosure may be implemented is limited only by the ability to apply the mathematical formulations described below to the particular system at hand.

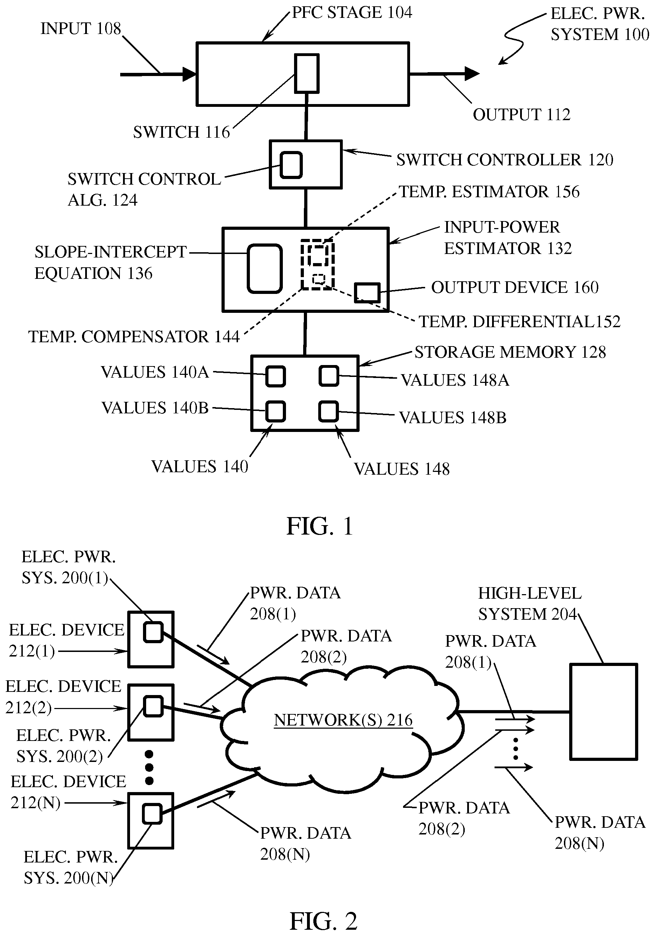

FIG. 1 illustrates an example electrical-power system 100. The electrical-power system 100 includes a PFC stage 104 that has an input 108, which receives electrical power from an alternating current (AC) power source (not shown), and an output 112, which provides power to one or more loads (not shown). The power source and load(s) may be any power source and load(s) compatible with the electrical-power system 100. The PFC stage 104 includes a switch 116, such as a MOSFET, that controls the operation of the PFC stage 104. The PFC stage 104 may be, for example, a boost type stage or a flyback stage, and may operate in any suitable current conduction mode, i.e., a critical conduction mode, a continuous conduction mode, or a discontinuous conduction mode. In this connection, various equations are presented and derived below for an example critical conduction mode boost-type PFC stage. However, as those skilled in the art will appreciate, those equations can be adapted for other types of PFC stages; essentially, only the constants in the equations will change for differing types of PFC stages. Those skilled in the art will readily understand how to adapt the equations below to PFC stages other than the critical conduction mode boost-type PFC stage used to illustrate the basic principles of the methodologies applied herein.

The electrical-power system 100 also includes a switch controller 120 that is in operative communication with the switch 116 of the PFC stage 104 so as to control the operation of the switch 116 and the PFC stage 104 in accordance with a switch control algorithm 124 suitable for the PFC device at issue. In one example in which the switch 116 is a MOSFET having a gate, the switch controller 120 controls the gate of the MOSFET. Those skilled in the art will readily understand that another type of switch can be used for the switch 116, as well as the configuration of the switch controller 120 needed to control the switch.

The electrical-power system 100 further includes a memory 128 and an input-power estimator 132 that is in operative communication with the memory 128 and the switch controller 120. The input-power estimator 132 is configured to solve a slope-intercept equation 136 that estimates the input power input into the PFC stage 104. In some embodiments, the slope-intercept equation 136 is a function of the on-time of the switch 116 and the voltage input into the PFC stage 104, and includes a plurality of slope constants and a plurality of y-intercept constants (not illustrated). A detailed derivation of a slope-intercept equation suitable for use as the slope-intercept equation 136 is presented below relative to a critical conduction mode boost-type PFC stage. Values 140 of the slope constants and the y-intercept constants, i.e., slope-constant values 140A and y-intercept-constant values 140B, are stored in the memory 128 and retrieved by the input-power estimator 132 as needed to solve the slope-intercept equation 136. As described below, the slope-constant and y-intercept-constant values 140 can be determined for each instantiation of the PFC stage 104, since the operating characteristics of the PFC stage 104 can vary from one instantiation to another, for example, due to variability in the individual electronic elements (e.g., inductor(s), resistor(s), capacitor(s), switch(es), diode(s), etc.) that make up each particular instantiation.

The input-power estimator 132 may optionally include a temperature compensator 144 that adjusts the slope-constant values 140A and the y-intercept-constant values 140B based on the temperature at which the PFC stage 104 is operating. In some embodiments, the temperature compensator 144 utilizes a plurality of temperature-compensation constant values 148, namely, a plurality of slope-constant temperature-compensation constant values 148A and a plurality y-intercept-constant temperature-compensation constant values 148B, and a temperature differential 152 to determine a plurality of slope-constant temperature-compensation values and a plurality y-intercept-constant temperature-compensation values that are used to adjust the slope-constant values 140A and the y-intercept-constant values 140B for the current temperature of the electrical-power system 100. The plurality of temperature-compensation values 148, here, the plurality of slope-constant temperature-compensation constant values 148A and the plurality of y-intercept-constant temperature-compensation constant values 148B, are stored in the memory 128. The temperature differential 152 may be determined using a temperature estimator 156. Details of an example of implementing the temperature estimator 144 are described below.

The memory 128 can be any one or more types of memory, such as non-volatile memory, among others. The switch controller 120 and the input-power estimator 132 may be implemented using any suitable hardware and/or software. For example, the switch controller 120 and the input-power estimator 132 may be implemented in a single microcontroller (not shown), such as a microcontroller that may have otherwise been provided to implement the switch controller. If such a microcontroller implementation is used, the memory 128 may be located onboard the microcontroller. Microcontrollers are already used in many PFC applications to control the PFC stages. Consequently, implementing an input-power estimator of the present disclosure, such as input-power estimator 132 of FIG. 1, in such a microcontroller would be straightforward in view of the present disclosure. No additional circuitry is required; generally only the firmware of the microcontroller needs to be updated. Therefore, the implementation cost to a manufacturer is minimal.

The input-power estimator 132 includes an output device 160 to communicate, offboard the input-power estimator, the calculated input power input into the PFC device 104. The output device 160 may be any suitable wired device (e.g., communications port) or wireless device (e.g., radio-frequency or optical communication device), or any combination thereof.

FIG. 2 illustrates a simple scenario in which a number, N, of electronic devices 200(1) to 200(N) are in communication with a higher-level system 204 that utilizes input-power data 208(1) to 208(N) generated aboard the electronic devices. Each of the electronic devices 200(1) to 200(N) includes respective electrical-power systems 212(1) to 212(N) that are configured to generate the input-power data 208(1) to 208(N) in accordance with aspects disclosed herein. In some embodiments, each electrical-power system 212(1) to 212(N) has the general configuration of the electrical-power system 100 of FIG. 1 and, therefore, generates the input-power data 208(1) to 208(N) in the manner described above and illustrated below.

The higher-level system 204 may be configured to use the utilize power data 208(1) to 208(N) in any number of ways. For example, the higher-level system 204 may be configured to collect the power data 208(1) to 208(N), use the power data 208(1) to 208(N) to make power-usage decisions, control the electronic devices 200(1) to 200(N) based on the power data 208(1) to 208(N), determine billing amounts for power consumption by the electronic devices 200(1) to 200(N), communicate the power data 208(1) to 208(N) and/or information derived therefrom to another system (not shown), and/or control one or more other electronic devices (not shown) based on the power data 208(1) to 208(N), among other things. As shown in FIG. 2, each electrical-power system 212(1) to 212(N) is in operative communication with the higher-level system 204 via one or more data communications networks 216, which may be and/or include a local-area network, a wide-area network, a global network (such as the Internet), and a deep-space network, among others, and any combination thereof.

Here, for example, an electrical-power system is composed of a constant-voltage digital addressable lighting interface (DALI) device that includes a PFC stage that is of the boost type and has a critical conduction mode. An example of such a DALI device is the OT50 DALI available from OSRAM. In the discussion below, the DALI device is referred to as the "driver". Table 1 below provides various nomenclature used throughout.

Table 1

| Variable Name | Description |
|---|---|
| $u_{in}$ | Instantaneous input voltage of the PFC converter |
| $i_{in}$ | Instantaneous input current of the PFC converter |
| $p_{in}$ | Instantaneous input power of the PFC converter |
| $i_L$ | Instantaneous inductor current |
| $\langle \cdot \rangle$ | Moving average operator. Averaging period is either over one mains cycle (60Hz in US) or over one switching cycle. Averaging period is specified in the context. |
| $P_{in,ave}$ | Average input power over a mains cycle (60Hz in US) |
| $U_{in,rms}$ | RMS input voltage of the PFC converter |
| $I_{in,rms}$ | RMS input current of the PFC converter |
| $I_{in,ave}$ | Average rectified input current of the PFC stage after the diode bridge |
| $U_{out}$ | Output voltage of the PFC converter |
| $P_{loss,br}$ | Average power loss in the diode bridge |
| $L$ | Inductance of the inductor |
| $V_d$ | Voltage drop of a single diode in the diode bridge |

(continued)

| Variable Name | Description |
|---|---|
| $r_d$ | On-resistance of a single diode in the diode bridge |
| $\eta$ | PFC converter's efficiency |
| $T$ | Mains period (16.7ms in US) |
| $\omega$ | Angular frequency of the input voltage ($\sim$377radian/second in US) |
| $f_{sw}$ | Instantaneous switching frequency of the PFC switch |
| $t_{on}$ | Average on-time that is the output of the low-bandwidth PID controller |
| $T_{ref}$ | Reference temperature (usually 25°C) |
| $T$ | Current temperature |
| $\Delta T$ | Temperature difference between current temperature and reference temperature. |
| $C$ | Correction factor used for adjusting the input power calculation |
| $u_{in,k}$ | Input voltage sampled at $k^{th}$ switching cycle, counted from start of a mains cycle |
| $\langle p_{in} \rangle_k$ | Average input power in $k^{th}$ switching cycle, counted from start of a mains cycle |
| $i_{L,pk}$ | Peak inductor current during a switching cycle |
| $t_{on,k}$ | $k^{th}$ on-time applied to the PFC switch, counted from start of a mains cycle |
| $t_{off,k}$ | $k^{th}$ off time of the PFC switch, counted from start of a mains cycle |
| $T_{sw,k}$ | $k^{th}$ switching period counted from start of a mains cycle |
| $S_k$ | $k^{th}$ scaling factor used to scale the average on-time, $t_{on}$, for THD and power factor optimization, counted from start of a mains cycle |
| $\varphi_k$ | $k^{th}$ sampled phase of the input voltage, counted from start of a mains cycle |
| $m$ | General-purpose slope |
| $b$ | General-purpose y-intercept |
| $m_k$ | Indexed coefficient for calculating the slope $m$. |
| $b_k$ | Indexed coefficient for calculating the y-intercept $b$. |
| $M_k$ | Indexed measured slope |
| $B_k$ | Indexed measured y-intercept |
| $S_L^{P_{in,driver}}$ | Sensitivity of the input power with respect to variations in the inductance of the inductor, in %/% unit |
| $m_k'$ | Indexed coefficient for calculating the slope $m$, modified to account for temperature variations. |
| $b_k'$ | Indexed coefficient for calculating the y-intercept $b$, modified to account for temperature variations. |
| $k_{m,i}$ | $i^{th}$ temperature coefficient used for calculating $m_i'$. |
| $k_{b,i}$ | $i^{th}$ temperature coefficient used for calculating $b_i'$. |
| $M_{(k)}^{T_{ref}}$ | Indexed measured slope, measured at temperature $T_{ref}$ |
| $M_{(k)}^{T_{max}}$ | Indexed measured slope, measured at temperature $T_{max}$ |

(continued)

| Variable Name | Description |
|---|---|
| $B_{(k)}^{T_{\text{ref}}}$ | Indexed measured y-intercept, measured at temperature $T_{\text{ref}}$ |
| $B_{(k)}^{T_{\max}}$ | Indexed measured y-intercept, measured at temperature $T_{\max}$ |
| $M_{(k)}^{\Delta T}$ | Defined as $M_{(k)}^{T_{\max}} - M_{(k)}^{T_{\text{ref}}}$ |
| $B_{(k)}^{\Delta T}$ | Defined as $B_{(k)}^{T_{\max}} - B_{(k)}^{T_{\text{ref}}}$ |

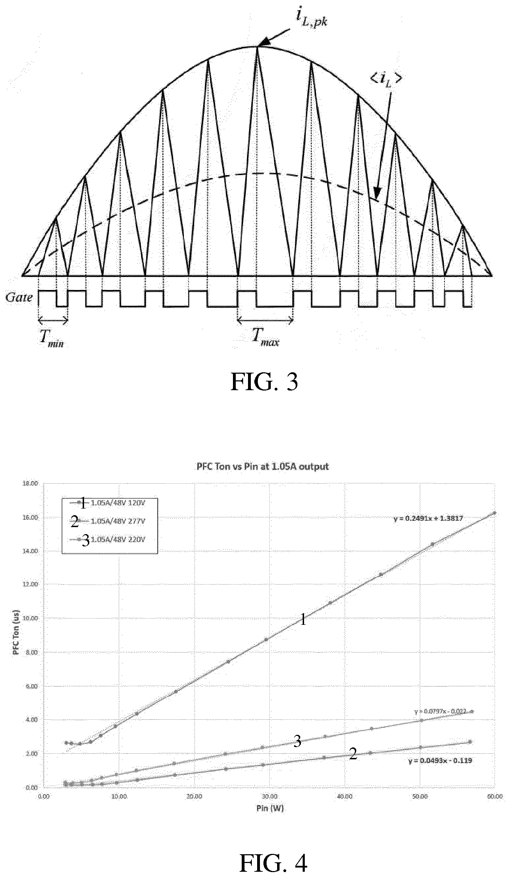

In a critical conduction mode of the PFC stage, the input current profile bounces between zero and the peak current value, $i_{L,pk}$, in a piecewise fashion as shown in FIG. 3. Since the PFC is a boost-type PFC,

$$\langle i_{\text{L}} \rangle = \langle i_{\text{in}} \rangle \tag{1}$$

where $\langle \cdot \rangle$ is the moving average operator over a switching cycle, $T_{sw}$. It is stressed that the averaging function is performed over the switching cycle, $T_{sw}$, and not over the 60Hz mains cycle, $T$. The average input power during each switching cycle is:

$$\langle p_{\text{in}} \rangle = \langle u_{\text{in}} i_{\text{L}} \rangle \tag{2}$$

Since $u_{\text{in}}$ is almost constant during a single switching cycle (assuming high enough switching frequency), then:

$$\langle p_{\text{in}} \rangle = u_{\text{in}} \langle i_{\text{L}} \rangle = u_{\text{in}} \cdot \frac{1}{2} i_{\text{L,pk}} = u_{\text{in}} \cdot \frac{1}{2} \frac{u_{\text{in}}}{L} t_{\text{on}} = \frac{u_{\text{in}}^2}{2L} t_{\text{on}} \tag{3}$$

The switching cycle lengths are not equal in the critical conduction mode (i.e., there is a variable switching frequency), and so the overall average power during a 60Hz mains cycle can be calculated as:

$$P_{\text{in,ave}} = \frac{\sum_k \langle p_{\text{in}} \rangle_k T_{\text{sw},k}}{\sum_k T_{\text{sw},k}} = \frac{\sum_k \langle p_{\text{in}} \rangle_k T_{\text{sw},k}}{T} \tag{4}$$

where $T$ is 16.7ms for 60Hz mains voltage. Now,

$$P_{\text{in,ave}} = \sum_k \frac{u_{\text{in},k}^2}{2L} t_{\text{on},k} \frac{T_{\text{sw},k}}{T} \tag{5}$$

Although it is expected that $t_{\text{on}}$ should be constant in all switching cycles in steady-state, in practice, some scaling factors are used to scale $t_{\text{on}}$ based on the phase of the input voltage in the microcontroller's code, in order to improve the total harmonic distortion (THD). Therefore,

$$t_{\text{on},k} = t_{\text{on}} S_k \tag{6}$$

where Sk is the corresponding scaling factor. Thus, equation (5) can be written as:

$$P_{\mathrm{in,ave}} = \sum_k \frac{u_{\mathrm{in},k}^2}{2L} t_{\mathrm{on}} S_k \frac{T_{\mathrm{sw},k}}{T} = \frac{t_{\mathrm{on}}}{2LT} \sum_k u_{\mathrm{in},k}^2 S_k T_{\mathrm{sw},k} \tag{7}$$

Now,

$$u_{\mathrm{in},k} = \sqrt{2} U_{\mathrm{in,rms}} \sin(\varphi_k) \tag{8}$$

and

$$t_{\mathrm{off},k} = \frac{u_{\mathrm{in},k}}{U_{\mathrm{out}} - u_{\mathrm{in},k}} t_{\mathrm{on},k} = \frac{u_{\mathrm{in},k}}{U_{\mathrm{out}} - u_{\mathrm{in},k}} t_{\mathrm{on}} S_k \tag{9}$$

$$T_{\mathrm{sw},k} = t_{\mathrm{on},k} + t_{\mathrm{off},k} = \frac{U_{\mathrm{out}}}{U_{\mathrm{out}} - u_{\mathrm{in},k}} t_{\mathrm{on}} S_k \tag{10}$$

where $U_{\mathrm{out}}$ is the output voltage of the PFC boost converter, i.e. the rail voltage. Substituting equations (8) and (10) into (7), it can be found:

$$P_{\mathrm{in,ave}} = \frac{U_{\mathrm{in,rms}}^2}{2L} t_{\mathrm{on}} \left( \sum_k \sin^2(\varphi_k) S_k^2 \frac{U_{\mathrm{out}}}{U_{\mathrm{out}} - \sqrt{2} U_{\mathrm{in,rms}} \sin(\varphi_k)} \frac{2t_{\mathrm{on}}}{T} \right) \tag{11}$$

Equation (11) can be written as:

$$P_{\mathrm{in,ave}} = \frac{U_{\mathrm{in,rms}}^2}{2L} t_{\mathrm{on}} \times C \tag{12}$$

where C is a correction factor that depends on $U_{\mathrm{in,rms}}$ and $t_{\mathrm{on}}$:

$$C = \left( \sum_k \sin^2(\varphi_k) S_k^2 \frac{U_{\mathrm{out}}}{U_{\mathrm{out}} - \sqrt{2} U_{\mathrm{in,rms}} \sin(\varphi_k)} \frac{2t_{\mathrm{on}}}{T} \right) \tag{13}$$

Having the scaling factors, $S_k$, $U_{\mathrm{in,rms}}$, and $t_{\mathrm{on}}$, the correction factor, $C$, can be calculated. It is noted that the choices of $U_{\mathrm{in,rms}}$ and $t_{\mathrm{on}}$ also affect the number of the summation terms in the sigma operator, because the switching frequency in the critical conduction mode is a function of $U_{\mathrm{in,rms}}$ and $t_{\mathrm{on}}$ too, i.e.:

$$f_{\mathrm{sw}}(t) = \frac{U_{\mathrm{out}} - \sqrt{2} U_{\mathrm{in,rms}} \sin(\omega t)}{U_{\mathrm{out}}} \cdot \frac{1}{t_{\mathrm{on}}(t)} \tag{14}$$

The $P_{\mathrm{in,ave}}$ in equation (11) does not consider the power loss in the diode bridge, which comes before the PFC. The power loss in the diode bridge can be simply expressed as:

$$P_{\text{loss,br}} = 2V_d I_{\text{in,ave}} + 2r_d I_{\text{in,rms}}^2 = \frac{4\sqrt{2}}{\pi} V_d I_{\text{in,rms}} + 2r_d I_{\text{in,rms}}^2$$

$$= \frac{4\sqrt{2}}{\pi} V_d \frac{P_{\text{in,driver}}}{U_{\text{in,rms}}} + 2r_d \left(\frac{P_{\text{in,driver}}}{U_{\text{in,rms}}}\right)^2 \tag{15}$$

Considering equations (15) and (11), the exact total input power of the driver is:

$$P_{\text{in,driver}} = \frac{U_{\text{in,rms}}^2}{2L} t_{\text{on}} \left(\sum_k \sin^2(\varphi_k) S_k^2 \frac{U_{\text{out}}}{U_{\text{out}} - \sqrt{2}U_{\text{in,rms}}\sin(\varphi_k)} \frac{2t_{\text{on}}}{T}\right) + \frac{4\sqrt{2}}{\pi} V_d \frac{P_{\text{in,driver}}}{U_{\text{in,rms}}} + 2r_d \left(\frac{P_{\text{in,driver}}}{U_{\text{in,rms}}}\right)^2 \tag{16}$$

Equation (16) is a quadratic equation in terms of $P_{\text{in,driver}}$. It can be solved for $P_{\text{in,driver}}$, given $U_{\text{in,rms}}$, $t_{\text{on}}$, $L$, $V_d$, $r_d$, $T$, and a set of $\{S_k\}$. It is obvious that implementation of equation (16) in the microcontroller of the PFC is impractical. Below there is described a practical way of tackling this highly nonlinear equation.

It is desired to calculate the input power of the driver based on only the root mean square (rms) input voltage and the designated on-time of the MOSFET (without considering the scaling factors). To this end, equation (16) can be rewritten as a slope-intercept (line) equation in simple terms as:

$$P_{\text{in,driver}} = m t_{\text{on}} + b \tag{17}$$

where $m$ and $b$ are the slope and y-intercept of the linear approximation. These parameters ($m$ and $b$) are nonlinear functions of $U_{\text{in,rms}}$, i.e.:

$$\begin{cases} m = m(U_{\text{in,rms}}) \\ b = b(U_{\text{in,rms}}) \end{cases} \tag{18}$$

For the purpose of the discussion here, the linear expansion of nonlinear functions, similar to the well-known Taylor series expansion, is considered here. A Taylor series expansion is as follows:

$$f(x + \Delta x) \approx f(x) + \frac{f'(x)}{1!} \Delta x + \frac{f''(x)}{2!} \Delta x^2 + \cdots \tag{19}$$

Equation (19) inspires the expression of $m(U_{\text{in,rms}})$ and $b(U_{\text{in,rms}})$ as:

$$\begin{cases} m(U_{\text{in,rms}}) = m_1 U_{\text{in,rms}}^2 + m_2 U_{\text{in,rms}} + m_3 \\ b(U_{\text{in,rms}}) = b_1 U_{\text{in,rms}}^2 + b_2 U_{\text{in,rms}} + b_3 \end{cases} \tag{20}$$

resulting in:

$$P_{\text{in,driver}} = \left(m_1 U_{\text{in,rms}}^2 + m_2 U_{\text{in,rms}} + m_3\right) t_{\text{on}} + \left(b_1 U_{\text{in,rms}}^2 + b_2 U_{\text{in,rms}} + b_3\right) \tag{21}$$

It is shown below using the measurement data that considering the first three terms in the linear expansion as suggested in equation (21) will result in enough accuracy. The objective in this example, therefore, is to find values for the constants $m_1$, $m_2$, $m_3$, $b_1$, $b_2$, and $b_3$ in order to calibrate the power measurement formula. These values can then be saved in a memory and used during the operation of the electronic device at issue. Constants $m_1$, $m_2$, and $m_3$ are referred to herein as "slope constants", and constants $b_1$, $b_2$, and $b_3$ are referred to herein as "y-intercept constants".

For the purpose of calibration in this example, three sets of data are needed. The input power measurement should be done for three different values of $U_{\text{in,rms}}$ that are between $U_{\text{in,rms}}(\text{min})$ and $U_{\text{in,rms}}(\text{max})$. In some embodiments, it is recommended that the chosen $U_{\text{in,rms}}$ values are not close to $U_{\text{in,rms}}(\text{min})$ or $U_{\text{in,rms}}(\text{max})$ because of high nonlinearity near the lower and upper limits. Then for each $U_{\text{in,rms}}$, $P_{\text{in,driver}}$ is measured for different values of $t_{\text{on}}$ to obtain three different linear curves. An example set of $t_{\text{on}}$ versus $P_{\text{in,driver}}$ curves is shown in FIG. 4 for the example OT50 DALI mentioned above.

Using the linear regression method, the slope and y-intercept of each line is found and denoted by $\{M_1, B_1\}$, $\{M_2, B_2\}$, and $\{M_3, B_3\}$. Then the parameters of the model described in equation (21) can be expressed in terms of these slopes and intercepts as:

$$\begin{bmatrix} m_1 \\ m_2 \\ m_3 \end{bmatrix} = \begin{bmatrix} U_{\text{in1,rms}}^2 & U_{\text{in1,rms}} & 1 \\ U_{\text{in2,rms}}^2 & U_{\text{in2,rms}} & 1 \\ U_{\text{in3,rms}}^2 & U_{\text{in3,rms}} & 1 \end{bmatrix}^{-1} \begin{bmatrix} M_1 \\ M_2 \\ M_3 \end{bmatrix} \tag{22}$$

$$\begin{bmatrix} b_1 \\ b_2 \\ b_3 \end{bmatrix} = \begin{bmatrix} U_{\text{in1,rms}}^2 & U_{\text{in1,rms}} & 1 \\ U_{\text{in2,rms}}^2 & U_{\text{in2,rms}} & 1 \\ U_{\text{in3,rms}}^2 & U_{\text{in3,rms}} & 1 \end{bmatrix}^{-1} \begin{bmatrix} B_1 \\ B_2 \\ B_3 \end{bmatrix} \tag{23}$$

with parameters $m_1$, $m_2$, and $m_3$ being a plurality of slope constants and the parameters $b_1$, $b_2$, and $b_3$ being a plurality of y-intercept constants as noted below.

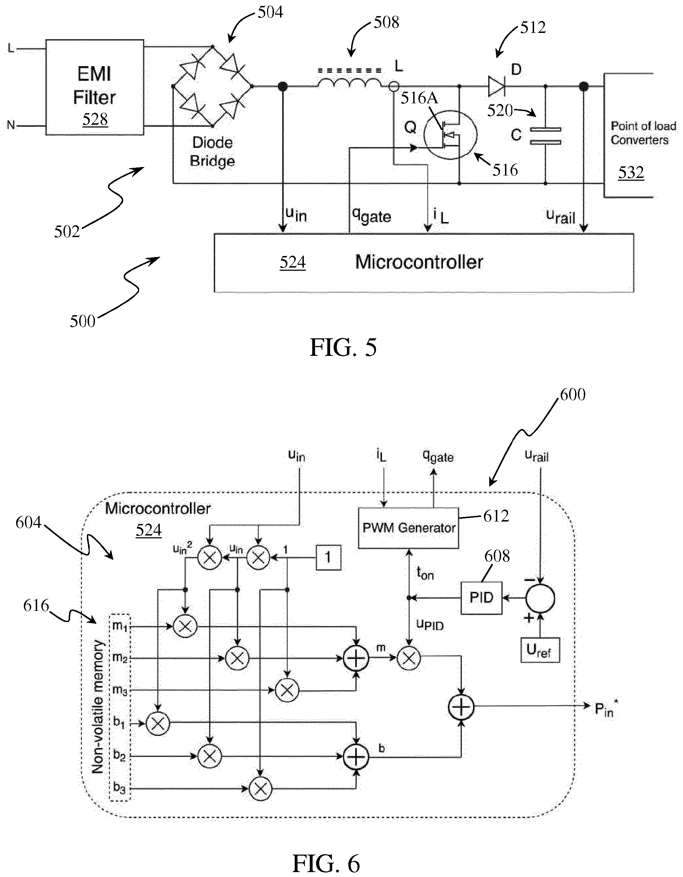

A circuit diagram of an example front-end boost-type PFC converter 500 is shown in FIG. 5. As seen in FIG. 5, the front-end boost-type PFC converter 500 includes a PFC stage 502 having a rectifying diode bridge 504, an inductor 508, a diode 512, a switch 516, and a capacitor 520 providing a filter. The front-end boost-type PFC converter 500 also includes a microcontroller 524 to control the gate 516A of the switch 516. The input to the rectifying diode bridge 504, i.e., the AC source (not shown), is put through an electromagnetic interference (EMI) filter 528, and the output is provided to a load, here, a point of load converters 532. The input voltage, $u_{\text{in}}$, the inductor 508 current's zero-current-detection (ZCD) signal, and the rail voltage, $u_{\text{rail}}$, are measured and fed into the microcontroller 524, which generates a gate signal, $q_{\text{gate}}$, for the switch 516. The fundamental operation of the PFC stage 502 in providing power factor correction is the same as the operation of conventional PFC stages, such that further explanations of that aspect of the PFC stage 502 and the microcontroller 524 are not necessary for those skilled in the art to understand the scope of the present disclosure.

One prevalent control method for a PFC stage, such as the PFC stage 502, is a combination of a proportional, integral, derivative (PID) controller, which regulates the rail voltage, and a zero current detector (ZCD) that ensures operation in critical conduction mode. The information necessary for input power estimation is already available when using this control strategy. FIG. 6 is a diagram of the microcontroller 524 of FIG. 5 that depicts a closed-loop switch controller 600 to control the gate 516A of the switch 516 of FIG. 5 and an input-power estimator 604 that estimates the power input, $P^*_{\text{in}}$, into the front-end boost-type PFC converter 500.

Referring to FIG. 6, the closed-loop switch controller 600 includes a PID compensator 608 and a pulse-width modulated (PWM) generator 612. The PID compensator 608 operates on the difference between the rail voltage $u_{\text{rail}}$ and a reference voltage, $U_{\text{ref}}$. The output of the PID compensator 608, i.e., $u_{\text{PID}}$, is the reference on-time, $t_{\text{on}}$, for the switch 516 of FIG. 5, because if the rail voltage $u_{\text{rail}}$ is less than the reference voltage $U_{\text{ref}}$ then $t_{\text{on}}$ must be increased and *vice versa*. The PWM generator 612 utilizes $t_{\text{on}}$ and an inductor current $i_{\text{L}}$ to generate a gate signal $q_{\text{gate}}$. The input-power estimator 604 is configured to solve equation (21) to calculate an estimated power $P^*_{\text{in}}$, which is equivalent to the $P_{\text{in,driver}}$ of equation (21). In this example, values of slope constants $m_1$, $m_2$, and $m_3$ and y-intercept constants $b_1$, $b_2$, and $b_3$ are stored in a memory 616 of the microcontroller 524. The estimated input power, $P^*_{\text{in}}$, can be used for energy metering purpose if it is multiplied by the time-interval between subsequent $P^*_{\text{in}}$ calculations.

The purpose of the automated calibration procedure is to produce the parameters of the model described in equation (21), i.e., $m_1$, $m_2$, $m_3$, $b_1$, $b_2$, and $b_3$. At least nine operating points are required for three different input voltages, $\{U_{\text{in,rms,1}}, U_{\text{in,rms,2}}, U_{\text{in,rms,3}}\}$, and three different input powers, $\{P_{\text{in,driver,1}}, P_{\text{in,driver,2}}, P_{\text{in,driver,3}}\}$. The more operating points used for calibration, the more accurate the parameters would be. In some embodiments, it is recommended that eighteen operating points are employed for optimum accuracy (three input voltages and six input powers). The following step-by-step procedure describes a recommended calibration method.

Step 1: Three input voltages must be selected between the minimum and maximum input voltage. It is recommended that the input voltages are selected as follows:

$$\begin{cases} U_{\text{in,rms}(1)} = U_{\text{in,rms}}(\text{min}) \\ U_{\text{in,rms}(2)} = 0.5 U_{\text{in,rms}}(\text{min}) + 0.5 U_{\text{in,rms}}(\text{max}) \\ U_{\text{in,rms}(3)} = U_{\text{in,rms}}(\text{max}) \end{cases} \tag{24}$$

where $U_{\text{in,rms}}(\text{min})$ and $U_{\text{in,rms}}(\text{max})$ are the minimum and maximum rated input voltages, respectively.

Step 2: Five different output power levels are selected according to the rated output power of the LED driver, $P_{\text{out,rated}}$, as follows (the range of interest for meeting the standards is half load to full load).

$$\begin{cases} P_{\text{out}(1)} = 0.5 P_{\text{out,rated}} \\ P_{\text{out}(2)} = 0.6 P_{\text{out,rated}} \\ P_{\text{out}(3)} = 0.7 P_{\text{out,rated}} \\ P_{\text{out}(4)} = 0.8 P_{\text{out,rated}} \\ P_{\text{out}(5)} = 0.9 P_{\text{out,rated}} \\ P_{\text{out}(6)} = P_{\text{out,rated}} \end{cases} \tag{25}$$

Step 3: For each selected input voltage, $U_{\text{m,rms}(i)}$ ($i = \{1,2,3\}$), the output power of the driver is consecutively set to the $P_{\text{out}(j)}$ ($j = \{1, \dots ,6\}$) values by sending the commands to the microcontroller. The corresponding input powers and the on-times of the switch are measured and recorded in each case. These input powers and on-times are denoted by $P_{\text{in,driver}(i,j)}$ and $t_{\text{on}(i,j)}$ ($i = \{1,2,3\}$, $j = \{1, \dots ,6\}$). The input powers can be measured by a power analyzer while the on-times are read from the microcontroller of the PFC stage through serial communication. The table immediately below summarizes the measurement procedure.

| $U_{\text{in,rms}(1)}$ | $P_{\text{in,driver}(11)}$ | $P_{\text{in,driver}(12)}$ | $P_{\text{in,driver}(13)}$ | $P_{\text{in,driver}(14)}$ | $P_{\text{in,driver}(15)}$ | $P_{\text{in,driver}(16)}$ |
|---|---|---|---|---|---|---|
|  | $t_{\text{on}(11)}$ | $t_{\text{on}(12)}$ | $t_{\text{on}(13)}$ | $t_{\text{on}(14)}$ | $t_{\text{on}(15)}$ | $t_{\text{on}(16)}$ |
| $U_{\text{in,rmS}(2)}$ | $P_{\text{in,driver}(21)}$ | $P_{\text{in,driver}(22)}$ | $P_{\text{in,driver}(23)}$ | $P_{\text{in,driver}(24)}$ | $P_{\text{in,driver}(25)}$ | $P_{\text{in,driver}(26)}$ |
|  | $t_{\text{on}(21)}$ | $t_{\text{on}(22)}$ | $t_{\text{on}(23)}$ | $t_{\text{on}(24)}$ | $t_{\text{on}(25)}$ | $t_{\text{on}(26)}$ |
| $U_{\text{in,rms}(3)}$ | $P_{\text{in,driver}(31)}$ | $P_{\text{in,driver}(32)}$ | $P_{\text{in,driver}(33)}$ | $P_{\text{in,driver}(34)}$ | $P_{\text{in,driver}(35)}$ | $P_{\text{in,driver}(36)}$ |
|  | $t_{\text{on}(31)}$ | $t_{\text{on}(32)}$ | $t_{\text{on}(33)}$ | $t_{\text{on}(34)}$ | $t_{\text{on}(35)}$ | $t_{\text{on}(36)}$ |

Step 4: The slopes and y-intercepts of the three $P_{\text{in}}$-versus-$t_{\text{on}}$ curves, which are denoted by $M_{(i)}$ and $B_{(i)}$ ($i = \{1,2,3\}$), are calculated used the linear regression method as follows.

$$\begin{cases} M(i) = \left[ \sum_{j=1}^{6} t_{\text{on}(ij)} P_{\text{in,driver}(ij)} - \frac{1}{6} \left( \sum_{j=1}^{6} t_{\text{on}(ij)} \right) \left( \sum_{j=1}^{6} P_{\text{in,driver}(ij)} \right) \right] \Big/ \left[ \sum_{j=1}^{6} t_{\text{on}(ij)}^2 - \frac{1}{6} \left( \sum_{j=1}^{6} t_{\text{on}(ij)} \right)^2 \right] \\ B(i) = \frac{1}{6} \left( \sum_{j=1}^{6} P_{\text{in,driver}(ij)} \right) - M(i) \times \frac{1}{6} \left( \sum_{j=1}^{6} t_{\text{on}(ij)} \right) \end{cases} \tag{26}$$

Step 5: After finding $M_{(i)}$s and $B_{(i)}$s ($i = \{1,2,3\}$), the values of slope constants $m_1$, $m_2$, and $m_3$ and y-intercept constants $b_1$, $b_2$, and $b_3$ are calculated based on equations (22) and (23) as follows.

$$\begin{bmatrix} m_1 \\ m_2 \\ m_3 \end{bmatrix} = \begin{bmatrix} U^2_{\text{in,rms}(1)} & U_{\text{in,rms}(1)} & 1 \\ U^2_{\text{in,rms}(2)} & U_{\text{in,rms}(2)} & 1 \\ U^2_{\text{in,rms}(3)} & U_{\text{in,rms}(3)} & 1 \end{bmatrix}^{-1} \begin{bmatrix} M_{(1)} \\ M_{(2)} \\ M_{(3)} \end{bmatrix} \tag{27}$$

$$\begin{bmatrix} b_1 \\ b_2 \\ b_3 \end{bmatrix} = \begin{bmatrix} U^2_{\text{in,rms}(1)} & U_{\text{in,rms}(1)} & 1 \\ U^2_{\text{in,rms}(2)} & U_{\text{in,rms}(2)} & 1 \\ U^2_{\text{in,rms}(3)} & U_{\text{in,rms}(3)} & 1 \end{bmatrix}^{-1} \begin{bmatrix} B_{(1)} \\ B_{(2)} \\ B_{(3)} \end{bmatrix} \tag{28}$$

These formulas can be embedded in an automatic calibration device to accelerate the production line.

Step 6: The calculated values for the slope constants, $m_1$, $m_2$, $m_3$, and the y-intercept constants $b_1$, $b_2$, $b_3$, are loaded in, for example, an EEPROM of a microcontroller for a PFC stage.

An important issue regarding the model represented by equation (21) is to address how much the tolerances of the electronic components in different units can affect the parameters of this model. This is important in determining whether one set of values for the slope and y-intercept constants can be used every manufactured device of the same type or whether each device needs to be calibrated by itself.

To address this issue, it is noted that the main circuit component that affects the formula for calculating the input power in equation (16) is an inductor of a PFC stage. According to equation (16), the parameters of the diode bridge, $V_d$ and $r_d$, can also affect the formula, but their contributions are minimal compared to that of the $L$. By neglecting the terms belonging to the losses in the diode bridge in equation (16), the input power formula can be written as:

$$P_{\text{in,driver}} = \frac{k}{L} \tag{29}$$

where k is a number that is independent of $L$. Therefore, the sensitivity of $P_{\text{in,driver}}$ with respect to $L$, which is defined as the ratio of the percentage change in $P_{\text{in,driver}}$ to the percentage change in $L$ can be found as:

$$S_L^{P_{\text{in,driver}}} = \frac{\frac{\partial P_{\text{in,driver}}}{P_{\text{in,driver}}}}{\frac{\partial L}{L}} =$$

$$\frac{\partial P_{\text{in,driver}}}{\partial L} \times \frac{L}{P_{\text{in,driver}}} = \frac{-k}{L^2} \times \frac{L}{k/L} = -1 \tag{30}$$

For example, according to equation (30), a 5% change in $L$ will translate to -5% change in the measured input power. Since the tolerance of the magnetic components is always around 5% to 10%, it may be desirable to calibrate each unit by itself during the manufacturing process.

Temperature can affect the error of the method described above. For example, testing on OT50 DALI noted above revealed that the maximum error percentage reached a maximum of about +10% at 80°C for $U_{\text{in}}$ = 120V during tests at 25°C, 50°C, and 80°C. Although such an error may be acceptable for non-revenue grade power metering, revenue-grade power metering requires higher accuracy at high temperatures, such as the at 80°C used during the temperature testing. The following subsections describe an example temperature calibration method for reducing temperature-induced error.

Extensive measurements made during experimentation show that the slope and y-intercept constants {$m_1$, $m_2$, $m_3$, $b_1$, $b_2$, $b_3$} drift slightly as temperature rises. In other words, the power estimator formula in equation (21) may be modified as follows:

$$P_{\text{in}} = \left(m_1' U^2_{\text{in,rms}} + m_2' U_{\text{in,rms}} + m_3'\right)t_{\text{on}} + \left(b_1' U^2_{\text{in,rms}} + b_2' U_{\text{in,rms}} + b_3'\right) \tag{31}$$

where

$$\begin{cases} m'_1 = m_1 + k_{m1}\Delta T \\ m'_2 = m_2 + k_{m2}\Delta T \\ m'_3 = m_3 + k_{m3}\Delta T \\ b'_1 = b_1 + k_{b1}\Delta T \\ b'_2 = b_2 + k_{b2}\Delta T \\ b'_3 = b_3 + k_{b3}\Delta T \end{cases}$$

(32)

and

$$\Delta T = T - T_{\text{ref}}(= 25°C)$$

(33)

The problem, thus, can be redefined as finding a way to obtain values for the temperature-compensation constants described in equation set (32), namely, the slope-constant temperature-compensation constants $k_{m1}$, $k_{m2}$, and $k_{m3}$ and the y-intercept-constant temperature-compensation constants $k_{b1}$, $k_{b2}$, and $k_{b3}$. It is noted that in equation set (32) the terms $k_{m1}\Delta T$, $k_{m2}\Delta T$, and $k_{m3}\Delta T$ are referred to as "slope-constant temperature-compensation values", and the terms $k_{b1}\Delta T$, $k_{b2}\Delta T$, and $k_{b3}\Delta T$ are referred to as "y-intercept-constant temperature-compensation values".

In order to obtain values for the temperature-compensation constants {$k_{m1}$, $k_{m2}$, $k_{m3}$, $k_{b1}$, $k_{b2}$, $k_{b3}$}, another set of measurements is needed at $T_{\text{max}}(= 80°C)$ in addition to the original measurements done at $T_{\text{ref}}(= 25°C)$. The same procedure as the one described above in steps 1-4 should be followed at $T_{\text{max}}(= 80°C)$ to find $\{M_{(1)}^{T\text{max}}, M_{(2)}^{T\text{max}}, M_{(3)}^{T\text{max}}, B_{(1)}^{T\text{max}}, B_{(2)}^{T\text{max}}, B_{(3)}^{T\text{max}}\}$. Steps 5-6 above are not needed to be done at $T_{\text{max}}$. The table immediately below summarizes the results at $T_{\text{ref}}(= 25°C)$ and $T_{\text{max}}(= 80°C)$. In this example, the first step in finding the temperature compensation constants is to populate this table.

| | $U_{\text{in,rms}(1)} = U_{\text{in,rms}}(\text{min})$ | $U_{\text{in,rms}(2)} = 0.5U_{\text{in,rms}}(\text{min}) + 0.5U_{\text{in,rms}}(\text{max})$ | $U_{\text{in,rms}(3)} = U_{\text{in,rms}}(\text{max})$ |
|---|---|---|---|
| °C @ $T_{\text{ref}}$ = 25°C | $M_{(1)}^{T\text{ref}} = M_{(1)} @ T_{\text{ref}}$ | $M_{(2)}^{T\text{ref}} = M_{(2)} @ T_{\text{ref}}$ | $M_{(3)}^{T\text{ref}} = M_{(3)} @ T_{\text{ref}}$ |
| | $B_{(1)}^{T\text{ref}} = B_{(1)} @ T_{\text{ref}}$ | $B_{(2)}^{T\text{ref}} = B_{(2)} @ T_{\text{ref}}$ | $B_{(3)}^{T\text{ref}} = B_{(3)} @ T_{\text{ref}}$ |
| @ $T_{max}$= 80°C | $M_{(1)}^{T\text{max}} = M_{(1)} @ T_{\text{max}}$ | $M_{(2)}^{T\text{max}} = M_{(2)} @ T_{\text{max}}$ | $M_{(3)}^{T\text{max}} = M_{(3)} @ T_{\text{max}}$ |
| | $B_{(1)}^{T\text{max}} = B_{(1)} @ T_{\text{max}}$ | $B_{(2)}^{T\text{max}} = B_{(2)} @ T_{\text{max}}$ | $B_{(3)}^{T\text{max}} = B_{(3)} @ T_{\text{max}}$ |

After that table immediately above has been populated, the differential slopes and intercepts, as defined in equation set (34), below, must be calculated.

$$\begin{cases} M_{(1)}^{\Delta T} = M_{(1)}^{T\text{max}} - M_{(1)}^{T\text{ref}} \\ M_{(2)}^{\Delta T} = M_{(2)}^{T\text{max}} - M_{(2)}^{T\text{ref}} \\ M_{(3)}^{\Delta T} = M_{(3)}^{T\text{max}} - M_{(3)}^{T\text{ref}} \\ B_{(1)}^{\Delta T} = B_{(1)}^{T\text{max}} - B_{(1)}^{T\text{ref}} \\ B_{(2)}^{\Delta T} = B_{(2)}^{T\text{max}} - B_{(2)}^{T\text{ref}} \\ B_{(3)}^{\Delta T} = B_{(3)}^{T\text{max}} - B_{(3)}^{T\text{ref}} \end{cases}$$

(34)

Here,

$$\Delta T = T_{\max} - T_{\text{ref}} \tag{35}$$

Considering equations (31), (32), (34), and (35), the following set of linear equations can be obtained for solving for values of the temperature compensation constants.

$$\begin{cases} M_{(1)}^{\Delta T} = \left(k_{m1}U_{\text{in,rms(1)}}^2 + k_{m2}U_{\text{in,rms(1)}} + k_{m3}\right)\Delta T \\ M_{(2)}^{\Delta T} = \left(k_{m1}U_{\text{in,rms(2)}}^2 + k_{m2}U_{\text{in,rms(2)}} + k_{m3}\right)\Delta T \\ M_{(3)}^{\Delta T} = \left(k_{m1}U_{\text{in,rms(3)}}^2 + k_{m2}U_{\text{in,rms(3)}} + k_{m3}\right)\Delta T \\ B_{(1)}^{\Delta T} = \left(k_{b1}U_{\text{in,rms(1)}}^2 + k_{b2}U_{\text{in,rms(1)}} + k_{b3}\right)\Delta T \\ B_{(2)}^{\Delta T} = \left(k_{b1}U_{\text{in,rms(2)}}^2 + k_{b2}U_{\text{in,rms(2)}} + k_{b3}\right)\Delta T \\ B_{(3)}^{\Delta T} = \left(k_{b1}U_{\text{in,rms(3)}}^2 + k_{b2}U_{\text{in,rms(3)}} + k_{b3}\right)\Delta T \end{cases} \tag{36}$$

There are 6 unknown variables, namely, the plurality of slope-constant temperature-compensation constants, $k_{m1}$, $k_{m2}$, and $k_{m3}$, and the plurality of y-intercept-constant temperature-compensation constants, $k_{b1}$, $k_{b2}$, and $k_{b3}$, and 6 linear equations in equation set (36). Therefore, the plurality of slope-constant temperature-compensation constant values $\{k_{m1}, k_{m2}, k_{m3}\}$ and the plurality of y-intercept-constant temperature compensation constant values $\{k_{b1}, k_{b2}, k_{b3}\}$ can be found as follows:

$$\begin{bmatrix} k_{m1} \\ k_{m2} \\ k_{m3} \end{bmatrix} = \frac{1}{\Delta T} \begin{bmatrix} U_{\text{in,rms(1)}}^2 & U_{\text{in,rms(1)}} & 1 \\ U_{\text{in,rms(2)}}^2 & U_{\text{in,rms(2)}} & 1 \\ U_{\text{in,rms(3)}}^2 & U_{\text{in,rms(3)}} & 1 \end{bmatrix}^{-1} \begin{bmatrix} M_{(1)}^{\Delta T} \\ M_{(2)}^{\Delta T} \\ M_{(3)}^{\Delta T} \end{bmatrix} \tag{37}$$

$$\begin{bmatrix} k_{b1} \\ k_{b2} \\ k_{b3} \end{bmatrix} = \frac{1}{\Delta T} \begin{bmatrix} U_{\text{in,rms(1)}}^2 & U_{\text{in,rms(1)}} & 1 \\ U_{\text{in,rms(2)}}^2 & U_{\text{in,rms(2)}} & 1 \\ U_{\text{in,rms(3)}}^2 & U_{\text{in,rms(3)}} & 1 \end{bmatrix}^{-1} \begin{bmatrix} B_{(1)}^{\Delta T} \\ B_{(2)}^{\Delta T} \\ B_{(3)}^{\Delta T} \end{bmatrix} \tag{38}$$

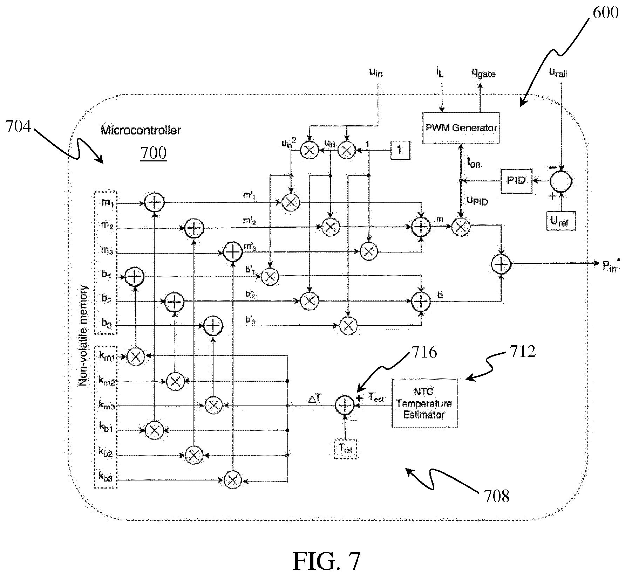

FIG. 7 illustrates a microcontroller 700 that includes temperature compensation as described immediately above. As can be seen comparing the microcontroller 524 of FIG. 6 to the microcontroller 700 of FIG. 6, the microcontroller 700 is a modified version of the microcontroller 524 of FIG. 6. The microcontroller 700 of FIG. 7 includes the same closed-loop switch controller 600 and essentially the same input-power estimator 604 of the microcontroller 524 of FIG. 6, but an input-power estimator 704 of the microcontroller 700 is augmented with a temperature compensator 708. The temperature compensator 708 includes a temperature estimator 712 that generates a temperature estimate, $T_{\text{est}}$, and a difference calculator 716 that calculates a difference, $\Delta T$, between $T_{\text{est}}$ and a reference temperature, $T_{\text{ref}}$. In FIG. 7, the temperature estimator 712 is of the negative-temperature coefficient (NTC) type, but it could be of another type, such as a positive-temperature coefficient type. The temperature estimator 712 is configured to modify the plurality of slope-constant values $\{m_1, m_2, m_3\}$ and the plurality y-intercept-constant values $\{b_1, b_2, b_3\}$ using the plurality of slope-constant temperature-compensation constant values $\{k_{m1}, k_{m2}, k_{m3}\}$, the plurality of y-intercept-constant temperature compensation constant values $\{k_{b1}, k_{b2}, k_{b3}\}$, and $\Delta T$ as indicated in equation set (32) to generate corresponding respective temperature-compensated slope-constant values $\{m'_1, m'_2, m'_3\}$ and temperature-compensated y-intercept-constant values $\{b'_1, b'_2, b'_3\}$, which are then used to determine $P_{\text{in}}^*$ in accordance with equation (31), with $P_{\text{in}}^*$ being equivalent to $P_{\text{in}}$ in equation (31).

Testing revealed that use of the above temperature-compensation method reduces the maximum error percentage at 80°C from 10% to 1.8% universally. In other words, for any $120V \le U_{\text{in}} \le 277V$, any $25W \le P_{\text{in}} \le 50W$, and any $25°C \le T_c \le 80°C$, the maximum error percentage is 1.8%.

The methods and systems described herein are not limited to a particular hardware or software configuration, and may find applicability in many computing or processing environments. The methods and systems may be implemented in hardware or software, or a combination of hardware and software. The methods and systems may be implemented in one or more computer programs, where a computer program may be understood to include one or more processor executable instructions. The computer program(s) may execute on one or more programmable processors, and may be stored on one or more storage medium readable by the processor (including volatile and non-volatile memory and/or storage elements), one or more input devices, and/or one or more output devices. The processor thus may access one or more input devices to obtain input data, and may access one or more output devices to communicate output data. The input and/ or output devices may include one or more of the following: Random Access Memory (RAM), Redundant Array of Independent Disks (RAID), floppy drive, CD, DVD, Blu-Ray, magnetic disk, internal hard drive, external hard drive, memory stick, flash drive, solid state memory device, or other storage device capable of being accessed by a processor as provided herein, where such aforementioned examples are not exhaustive, and are for illustration and not limitation.

The computer program(s) may be implemented using one or more high level procedural or object-oriented programming languages to communicate with a computer system; however, the program(s) may be implemented in assembly or machine language, if desired. The language may be compiled or interpreted.

As provided herein, the processor(s) may thus be embedded in one or more devices that may be operated independently or together in a networked environment, where the network may include, for example, a Local Area Network (LAN), wide area network (WAN), and/or may include an intranet and/or the internet and/ or another network. The network(s) may be wired or wireless or a combination thereof and may use one or more communications protocols to facilitate communications between the different processors. The processors may be configured for distributed processing and may utilize, in some embodiments, a client-server model as needed. Accordingly, the methods and systems may utilize multiple processors and/ or processor devices, and the processor instructions may be divided amongst such single- or multiple-processor/ devices.

The device(s) or computer systems that integrate with the processor(s) may include, for example, a personal computer(s), workstation(s), handheld device(s) such as cellular telephone(s) or smartphone(s) or tablet(s), laptop(s), laptop/tablet hybrid(s), handheld computer(s), smart watch(es), or any another device(s) capable of being integrated with a processor(s) that may operate as provided herein. Accordingly, the devices provided herein are not exhaustive and are provided for illustration and not limitation.

References to "a microprocessor" and "a processor", or "the microprocessor" and "the processor," may be understood to include one or more microprocessors that may communicate in a stand-alone and/or a distributed environment(s), and may thus be configured to communicate via wired or wireless communications with other processors, where such one or more processor may be configured to operate on one or more processor-controlled devices that may be similar or different devices. Use of such "microprocessor" or "processor" terminology may thus also be understood to include a central processing unit, an arithmetic logic unit, an application-specific integrated circuit (IC), and/or a task engine, with such examples provided for illustration and not limitation.

Furthermore, references to memory, unless otherwise specified, may include one or more processor-readable and accessible memory elements and/or components that may be internal to the processor-controlled device, external to the processor-controlled device, and/or may be accessed via a wired or wireless network using a variety of communications protocols, and unless otherwise specified, may be arranged to include a combination of external and internal memory devices, where such memory may be contiguous and/or partitioned based on the application. Accordingly, references to a database may be understood to include one or more memory associations, where such references may include commercially available database products (e.g., SQL, Informix, Oracle) and also proprietary databases, and may also include other structures for associating memory such as links, queues, graphs, trees, with such structures provided for illustration and not limitation.

References to a network, unless provided otherwise, may include one or more intranets and/or the internet. References herein to microprocessor instructions or microprocessor-executable instructions, in accordance with the above, may be understood to include programmable hardware.

Unless otherwise stated, use of the word "substantially" may be construed to include a precise relationship, condition, arrangement, orientation, and/or other characteristic, and deviations thereof as understood by one of ordinary skill in the art, to the extent that such deviations do not materially affect the disclosed methods and systems.

Throughout the entirety of the present disclosure, use of the articles "a" and/or "an" and/or "the" to modify a noun may be understood to be used for convenience and to include one, or more than one, of the modified noun, unless otherwise specifically stated. The terms "comprising", "including" and "having" are intended to be inclusive and mean that there may be additional elements other than the listed elements.

Elements, components, modules, and/or parts thereof that are described and/or otherwise portrayed through the figures to communicate with, be associated with, and/or be based on, something else, may be understood to so communicate, be associated with, and or be based on in a direct and/or indirect manner, unless otherwise stipulated herein.

Although the methods and systems have been described relative to a specific embodiment thereof, they are not so limited. Obviously many modifications and variations are possible within the scope of the appended claims.

**Claims**

1. A method of measuring power input to a system, comprising:

   providing an input-power estimator (132) configured to solve a slope-intercept equation for input power, $P_{in}$, wherein the slope-intercept equation is a function of on-time, $t_{on}$, of a switch (116) controlled by a switch controller (120) and an input voltage, $U_{in}$, input into a power factor compensation (PFC) stage (104) of the system and includes a plurality of slope constants (m1, m2, m3) and a plurality of y-intercept constants (b1, b2, b3), which are determined from a linear expansion of nonlinear functions (m(Uin), b(Uin)) of the input voltage Uin, and wherein the PFC stage (104) includes the switch (116);
   receiving a $t_{on}$ value from the switch controller (120);
   retrieving, from a memory (128), a plurality of slope-constant values and a plurality of y-intercept-constant values, loaded in the memory (128) during a calibration procedure of the input-power estimator (132); and
   solving the slope-intercept equation using the $t_{on}$ value, the input voltage $U_{in}$, the plurality of slope-constant values, and the plurality yintercept-constant values to determine $P_{in}$.

2. The method of claim 1, wherein the slope-intercept equation comprises a Taylor-series expansion of each of a non-linear slope equation and a non-linear y-intercept equation, wherein preferably each of the non-linear slope equation and the non-linear y-intercept equation is a non-linear function of $U_{in}$.

3. The method of claim 2, wherein the slope-intercept equation is:

$$P_{\mathrm{in,driver}} = \left(m_1 U_{\mathrm{in,rms}}^2 + m_2 U_{\mathrm{in,rms}} + m_3\right)t_{\mathrm{on}} + \left(b_1 U_{\mathrm{in,rms}}^2 + b_2 U_{\mathrm{in,rms}} + b_3\right)$$

   wherein $m_1$, $m_2$, and $m_3$ are the plurality of slope-constant values and $b_1$, $b_2$, and $b_3$ are the plurality of y-intercept-constant values.

4. The method of any one of claims 1 to 3, wherein the PFC stage (104) is a particular instantiation and the plurality of slope-constant values and the plurality y-intercept-constant values are calibrated values calibrated to the particular instantiation.

5. The method of any one of claims 1 to 4, wherein the switch controller (120) includes a proportion-integral-derivative (PID) controller, and receiving a $t_{on}$ value from the switch controller (120) comprises receiving the $t_{on}$ value from the PID controller.

6. The method of any one of claims 1 to 5, wherein the slope-intercept equation is further configured as a function of a temperature differential, $\Delta T$, and further comprises:

   a plurality of slope-constant temperature-compensation values corresponding respectively to the plurality of slope constants; and
   a plurality of y-intercept-constant temperature compensation values corresponding respectively to the plurality of y-intercept constants;

   and where the method further comprises:

   retrieving a plurality of slope-constant temperature-compensation constant values and a plurality of y-intercept-constant temperature compensation constant values from the memory (128);
   calculating the plurality of slope-constant temperature-compensation values and plurality of y-intercept-constant temperature-compensation values using, respectively, the plurality of slope-constant temperature-compensation constant values and the plurality of y-intercept-constant temperature-compensation constant values; and
   solving the slope-intercept equation using the $t_{on}$ value, the plurality of slope-constant values, the plurality y-intercept-constant values, the plurality of slope-constant temperature-compensation constant values, and the plurality of y-intercept-constant temperature-compensation constant values to determine $P_{in}$.

7. The method of claim 6, further comprising

receiving a $\Delta T$ value from a $\Delta T$ estimator; and
multiplying each of the plurality of slope-constant temperature-compensation constant values and the plurality of y-intercept-constant temperature-compensation constant values by the $\Delta T$ value to determine corresponding respective ones of the plurality of slope-constant temperature-compensation values and the plurality of y-intercept-constant temperature compensation values,
the method preferably further comprising adding the plurality of slope-constant temperature-compensation values and the plurality of y-intercept-constant temperature compensation values to corresponding respective ones of the plurality of slope-constant values and the plurality y-intercept-constant values to obtain a plurality of temperature-compensated slope-constant values and a plurality temperature-compensated y-intercept-constant values for use in the solving step in place of, respectively, the plurality of slope-constant values and the plurality y-intercept-constant values.

8. A device, comprising:
an electrical power system that comprises:

a power factor compensation (PFC) stage comprising a switch (116) and, during operation, has an input voltage, $U_{in}$;
a switch controller (120) in communication with the switch (116) and configured to provide an on-time, $t_{on}$, signal to the switch (116) so as to control the $t_{on}$ of the switch (116);
an input-power estimator (132) in operative communication with the PFC stage (104) and the switch controller (120), wherein the input-power estimator (132) is configured to solve a slope-intercept equation for input power, $P_{in}$, input into the PFC stage (104), wherein the slope-intercept equation is a function of $t_{on}$ and $U_{in}$, and includes a plurality of slope constants (m1, m2, m3) and a plurality of y-intercept constants (b1, b2, b3), which are determined from a linear expansion of nonlinear functions (m(Uin), b(Uin)) of the input voltage Uin; and
an output to communicate $P_{in}$ offboard of the input-power estimator (132); and
a memory (128) in operative communication with the input-power estimator (132), wherein the memory (128) contains a plurality of slope-constant values and a plurality of y-intercept-constant values, loaded in the memory (128) during a calibration procedure, for use by the input-power estimator (132) in solving the slope-intercept equation for $P_{in}$.

9. The device of claim 8, wherein the slope-intercept equation comprises a Taylor-series expansion of each of a non-linear slope equation and a non-linear y-intercept equation, wherein preferably each of the non-linear slope equation and the non-linear y-intercept equation is a non-linear function of $U_{in}$.

10. The device of claim 9, wherein retrieving a plurality of slope-constant values and a plurality of y-intercept-constant values includes retrieving three slope-constant values and three y-intercept-constant values, wherein preferably the slope-intercept equation is:

$$P_{in,driver} = \left(m_1 U_{in,rms}^2 + m_2 U_{in,rms} + m_3\right)t_{on} + \left(b_1 U_{in,rms}^2 + b_2 U_{in,rms} + b_3\right)$$

wherein $m_1$, $m_2$, and $m_3$ are the plurality of slope-constant values and $b_1$, $b_2$, and $b_3$ are the plurality of y-intercept-constant values.

11. The device of any one of claims 8 to 10, wherein the PFC stage (104) is a particular instantiation and the plurality of slope-constant values and the plurality y-intercept-constant values are calibrated values calibrated to the particular instantiation.

12. The device of any one of claims 8 to 11, wherein the slope-intercept equation is further configured as a function of a temperature differential, $\Delta T$, and further comprises:

a plurality of slope-constant temperature-compensation values corresponding respectively to the plurality of slope constants; and
a plurality of y-intercept-constant temperature compensation values corresponding respectively to the plurality of y-intercept constants; and wherein the memory (128) contains a plurality of slope-constant temperature-compensation constant values and a plurality of y-intercept-constant temperature compensation constant values.

**13.** The device of claim 12, further comprising:

a $\Delta T$ estimator configured to generate the $\Delta T$ value; and
a temperature compensator configured to multiply each of the plurality of slope-constant temperature-compensation constant values and the plurality of y-intercept-constant temperature compensation constant values by the $\Delta T$ value to determine corresponding respective ones of the plurality of slope-constant temperature-compensation values and the plurality of y-intercept-constant temperature compensation values,
wherein preferably the input-power estimator (132) is further configured to add the plurality of slope-constant temperature-compensation values and the plurality of y-intercept-constant temperature compensation values to corresponding respective ones of the plurality of slope-constant values and the plurality of y-intercept-constant values to obtain a plurality of temperature-compensated slope-constant values and a plurality temperature-compensated y-intercept-constant values for use in the solving step in place of, respectively, the plurality of slope-constant values and the plurality y-intercept-constant values.

**14.** A method of calibrating an input-power estimator (132) of an electrical power system in a device according to claim 8, the method comprising:

a. for each of a plurality of input voltage values, setting, in seriatim, a plurality of output power values;
b. measuring, for each combination of input voltage value and output voltage value, an input power, $P_{in}$, to the PFC stage (104) and a $t_{on}$ value;
c. calculating slopes (m) and y-intercepts (b) of a plurality of $P_{in}$ versus- $t_{on}$ curves;
d. using the slopes, the y-intercepts, and $U_{in}$, calculate a plurality of slope-constant values and a plurality of y-intercept-constant values corresponding, respectively, to the plurality of slope constants and the plurality of y-intercept constants; and
e. storing the plurality of slope-constant values and the plurality of y-intercept-constant values in the memory (128).

**15.** The method of claim 14, wherein the input-power estimator (132) is further calibrated for operating temperature, and the method further comprises:

performing acts a. through d. at a first temperature to obtain first slopes and first y-intercepts;
performing acts a. through d. at a second temperature different from the first temperature to obtain second slopes and second y-intercepts;
determining differential slopes between the second slopes and the first slopes and differential y-intercepts between the second y-intercepts and the first y-intercepts;
solving a set of differential equations that are a function of the input voltage values, a differential between the second and first temperatures, the differential slopes, the differential y-intercepts, a plurality of slope-constant temperature-compensation constant values, and a plurality of y-intercept-constant temperature compensation constant values so as to determine the plurality of slope-constant temperature-compensation constant values and the plurality of y-intercept-constant temperature compensation constant values; and
storing the plurality of slope-constant temperature-compensation constant values and the plurality of y-intercept-constant temperature compensation constant values in the memory (128).

**Patentansprüche**

**1.** Verfahren zum Messen der Eingangsleistung in ein System, umfassend:

Bereitstellen eines Eingangsleistungsschätzers (132), der konfiguriert ist, um eine Steigungs-Achsenabschnitts-Gleichung für die Eingangsleistung, $P_{in}$, zu lösen, wobei die Steigungs-Achsenabschnitts-Gleichung eine Funktion der Einschaltzeit, $t_{on}$, eines von einem Schaltregler (120) gesteuerten Schalters (116) und einer, einer Leistungsfaktor-Kompensations, PFC, - Stufe (104) des Systems zugeführten Eingangsspannung $U_{in}$ ist, und eine Mehrzahl von Steigungs-Konstanten (m1, m2, m3) und eine Mehrzahl von y-Achsenabschnitts-Konstanten (b1, b2, b3) enthält, die aus einer linearen Erweiterung von nichtlinearen Funktionen (m($U_{in}$), b($U_{in}$)) der Eingangsspannung $U_{in}$ bestimmt werden, und wobei die PFC-Stufe (104) den Schalter (116) aufweist;
Empfangen eines $t_{on}$ Werts von dem Schaltregler (120);

Abrufen aus einem Speicher (128) von einer Mehrzahl von Steigungs-Konstanten Werten und von einer Mehrzahl von y-Achsenabschnitts-Konstanten Werten, die während einer Kalibrierungsprozedur des Eingangsleistungsschätzers (132) in den Speicher (128) geladen wurden; und

Lösen der Steigungs-Achsenabschnitts-Gleichung unter Verwendung des $t_{on}$ Wertes, der Eingangsspannung $U_{in}$, der Mehrzahl von Steigungs-Konstanten Werte und der Mehrzahl von y-Achsenabschnitts-Konstanten Werte, um $P_{in}$ zu bestimmen.

2. Verfahren nach Anspruch 1, wobei die Steigungs-Achsenabschnitts-Gleichung eine Taylor-Reihen-Entwicklung von jeweils einer nichtlinearen Steigungs-Gleichung und einer nichtlinearen y-Achsenabschnitts-Gleichung umfasst, wobei vorzugsweise sowohl die nichtlineare Steigungs-Gleichung als auch die nichtlineare y-Achsenabschnitts-Gleichung eine nichtlineare Funktion von $U_{in}$ ist.

3. Verfahren nach Anspruch 2, wobei die Steigungs-Achsenabschnitts-Gleichung lautet:

$$P_{\text{in,driver}} = \left(m_1 U_{\text{in,rms}}^2 + m_2 U_{\text{in,rms}} + m_3\right)t_{\text{on}} + \left(b_1 U_{\text{in,rms}}^2 + b_2 U_{\text{in,rms}} + b_3\right)$$

wobei m1, m2 und m3 die Mehrzahl von Steigungs-Konstanten Werte sind und b1, b2 und b3 die Mehrzahl der y-Achsenabschnitts-Konstanten Werte sind.

4. Verfahren nach einem der Ansprüche 1 bis 3, wobei die PFC-Stufe (104) eine bestimmte Instanziierung ist, und die Mehrzahl von Steigungs-Konstanten Werte und die Mehrzahl von y-Achsenabschnitts-Konstanten Werte auf die bestimmte Instanziierung kalibrierte Werte sind.

5. Verfahren nach einem der Ansprüche 1 bis 4, wobei der Schaltregler (120) einen Proportional-Integral-Derivativ, PID, -Regler enthält und das Empfangen eines $t_{on}$ Werts vom Schaltregler (120) das Empfangen des $t_{on}$ Werts vom PID-Regler umfasst.

6. Verfahren nach einem der Ansprüche 1 bis 5, wobei die Steigungs-Achsenabschnitts-Gleichung weiterhin als Funktion eines Temperaturdifferentials, $\Delta T$, konfiguriert ist und weiterhin umfasst:

eine Mehrzahl von Steigungs-Konstanten-Temperaturkompensations Werten, die jeweilig der Mehrzahl von Steigungs-Konstanten zugeordnet sind; und

eine Mehrzahl von y-Achsenabschnitts-Temperaturkompensations Werten, die jeweilig der Mehrzahl von y-Achsenabschnitts-Konstanten zugeordnet sind; und wobei das Verfahren ferner umfasst:

Abrufen einer Mehrzahl von Steigungs-Konstanten-Temperaturkompensations-Konstanten Werte und einer Mehrzahl von y-Achsenabschnitts-Konstanten-Temperaturkompensations-Konstanten Werte aus dem Speicher (128);

Berechnen der Mehrzahl von Steigungs-Konstanten-Temperaturkompensations Werte und der Mehrzahl von y-Achsenabschnitts-Temperaturkompensations Werte unter Verwendung jeweils der Mehrzahl von Steigungs-Konstanten-Temperaturkompensations-Konstanten Werte und der Mehrzahl von y-Achsenabschnitts-Konstanten-Temperaturkompensations-Konstanten Werte; und

Lösen der Steigungs-Achsenabschnitts-Gleichung unter Verwendung des $t_{on}$ Werts, der Mehrzahl von Steigungs-Konstanten Werte, der Mehrzahl von y-Achsenabschnitts-Konstanten Werte, der Mehrzahl von Steigungs-Konstanten-Temperaturkompensations-Konstanten Werte und der Mehrzahl von y-Achsenabschnitts-Konstanten-Temperaturkompensations-Konstanten Werte, um $P_{in}$ zu bestimmen.

7. Verfahren nach Anspruch 6, ferner umfassend

Empfangen eines $\Delta T$ Werts von einem $\Delta T$ Schätzer; und

Multiplizieren von jedem aus der Mehrzahl von Temperaturkompensations-Konstanten Werte und aus der Mehrzahl von y-Achsenabschnitts-Konstanten-Temperaturkompensations-Konstanten Werte mit dem $\Delta T$ Wert, um entsprechende jeweilige aus der Mehrzahl von Steigungs-Konstanten-Temperaturkompensations Werten und aus der Mehrzahl von y-Achsenabschnitts-Konstanten-Temperaturkompensations Werten zu bestimmen,

wobei das Verfahren vorzugsweise ferner das Addieren der Mehrzahl von Steigungs-Konstanten-Temperaturkompensations Werte und der Mehrzahl von y-Achsenabschnitts-Konstanten-Temperaturkompensations Werte zu entsprechenden jeweiligen der Mehrzahl von Steigungs-Konstanten Werte und der Mehrzahl von y-Achsenabschnitts-Konstanten Werte umfasst, um eine Mehrzahl von temperaturkompensierten Steigungs-Konstanten Werte und eine Mehrzahl von temperaturkompensierten y-Achsenabschnitts-Konstanten Werte zur Verwendung in dem Lösungsschritt anstelle der Mehrzahl von Steigungs-Konstanten Werte bzw. der Mehrzahl von y-Achsenabschnitts-Konstanten Werte zu erhalten.

8. Eine Einrichtung, aufweisend:

ein Stromversorgungssystem, das umfasst:
eine Leistungsfaktor-Kompensationsstufe, PFC, die einen Schalter (116) umfasst und im Betrieb eine Eingangsspannung, $U_{in}$, aufweist;
einen Schaltregler (120), der mit dem Schalter (116) in Verbindung steht und konfiguriert ist, um dem Schalter (116) ein Einschaltzeit (on-time), $t_{on}$, -Signal zur Verfügung zu stellen, um die $t_{on}$ des Schalters (116) zu steuern;
einen Eingangsleistungsschätzer (132) in operativer Kommunikation mit der PFC-Stufe (104) und dem Schaltregler (120), wobei der Eingangsleistungsschätzer (132) konfiguriert ist, um eine Steigungs-Achsenabschnitts-Gleichung für die in die PFC-Stufe (104) eingegebene Eingangsleistung, $P_{in}$, zu lösen, wobei die Steigungs-Achsenabschnitts-Gleichung eine Funktion von $t_{on}$ und $U_{in}$ ist, und eine Mehrzahl von Steigungs-Konstanten (m1, m2, m3) und eine Mehrzahl von y-Achsenabschnitts-Konstanten (b1, b2, b3) aufweist, die aus einer linearen Erweiterung von nichtlinearen Funktionen (m($U_{in}$), b($U_{in}$)) der Eingangsspannung $U_{in}$ bestimmt werden; und
einen Ausgang um $P_{in}$ nach außerhalb vom Eingangsleistungsschätzer (132) zu kommunizieren; und
einen Speicher (128), der in operativer Kommunikation mit dem Eingangsleistungsschätzer (132) steht, wobei der Speicher (128) eine Mehrzahl von Steigungs-Konstanten Werten und eine Mehrzahl von y-Achsenabschnitts-Konstanten Werten enthält, die während einer Kalibrierungsprozedur in den Speicher (128) geladen werden, zur Verwendung durch den Eingangsleistungsschätzer (132) beim Lösen der Steigungs-Achsenabschnitts-Gleichung für $P_{in}$.

9. Einrichtung nach Anspruch 8, wobei die Steigungs-Achsenabschnitts-Gleichung eine Taylor-Serien-Entwicklung von jeweils einer nichtlinearen Steigungs-Gleichung und einer nichtlinearen y-Achsenabschnitts-Gleichung umfasst, wobei vorzugsweise jede der nichtlinearen Steigungs-Gleichung und der nichtlinearen y-Achsenabschnitts-Gleichung eine nichtlineare Funktion von $U_{in}$ ist.

10. Einrichtung nach Anspruch 9, wobei das Abrufen einer Mehrzahl von Steigungs-Konstanten Werten und einer Mehrzahl von y-Achsenabschnitts-Konstanten Werten das Abrufen von drei Steigungs-Konstanten Werten und von drei y-Achsenabschnitts-Konstanten Werten umfasst,
wobei vorzugsweise die Steigungs-Achsenabschnitts-Gleichung lautet:

$$P_{\text{in,driver}} = \left(m_1 U_{\text{in,rms}}^2 + m_2 U_{\text{in,rms}} + m_3\right)t_{\text{on}} + \left(b_1 U_{\text{in,rms}}^2 + b_2 U_{\text{in,rms}} + b_3\right)$$

wobei m1, m2 und m3 die Mehrzahl von Steigungs-Konstanten Werten sind und b1, b2 und b3 die Mehrzahl von y-Achsenabschnitts-Konstanten Werten sind.

11. Einrichtung nach einem der Ansprüche 8 bis 10, wobei die PFC-Stufe (104) eine bestimmte Instanziierung ist, und die Mehrzahl von Steigungs-Konstanten Werten und die Mehrzahl von y-Achsenabschnitts-Konstanten Werte auf die bestimmte Instanziierung kalibrierte Werte sind.

12. Einrichtung nach einem der Ansprüche 8 bis 11, wobei die Steigungs-Achsenabschnitts-Gleichung ferner als eine Funktion eines Temperaturdifferenzials, $\Delta T$, konfiguriert ist und ferner umfasst:

eine Mehrzahl von Steigungs-Konstanten-Temperaturkompensations Werten, die jeweils der Mehrzahl von Steigungs-Konstanten zugeordnet sind; und
eine Mehrzahl von y-Achsenabschnitts-Temperaturkompensations Werten, die jeweils der Mehrzahl von y-Achsenabschnitts-Konstanten zugeordnet sind; und
wobei der Speicher (128) eine Mehrzahl von Steigungs-Konstanten-Temperaturkompensations-Konstanten Werte und eine Mehrzahl von y-Achsenabschnitts-Konstanten-Temperaturkompensations-Konstanten Werte enthält.

13. Einrichtung nach Anspruch 12, ferner aufweisend:

einen $\Delta T$ Schätzer, der konfiguriert ist, um den $\Delta T$ Wert zu erzeugen; und

einen Temperaturkompensator, der konfiguriert ist, um jeden aus der Mehrzahl von Steigungs-Konstanten-Temperaturkompensations-Konstanten Werte und aus der Mehrzahl von y-Achsenabschnitts-Konstanten-Temperaturkompensations-Konstanten Werte mit dem $\Delta T$ Wert zu multiplizieren, um entsprechende jeweilige aus der Mehrzahl von Steigungs-Konstanten-Temperaturkompensations Werten und der Mehrzahl von y-Achsenabschnitts-Konstanten-Temperaturkompensations Werten zu bestimmen,

wobei vorzugsweise der Eingangsleistungsschätzer (132) ferner konfiguriert ist, um die Mehrzahl von Steigungskonstanten-Temperaturkompensations Werten und die Mehrzahl von y-Achsenabschnitts-Konstanten-Temperaturkompensations Werten zu entsprechenden jeweiligen der Mehrzahl von Steigungs-Konstanten-Werte und der Mehrzahl von y-Achsenabschnitts-Konstanten-Werte zu addieren, um eine Mehrzahl von temperaturkompensierten Steigungs-Konstanten Werten und eine Mehrzahl von temperaturkompensierten y-Achsenabschnitts-Konstanten-Werten zur Verwendung in dem Lösungsschritt anstelle der Mehrzahl von Steigungs-Konstanten Werte bzw. der Mehrzahl von y-Achsenabschnitts-Konstanten-Werte zu erhalten.

14. Verfahren zum Kalibrieren eines Eingangsleistungsschätzers (132) eines Stromversorgungssystems in einer Einrichtung nach Anspruch 8, wobei das Verfahren umfasst:

a. für jeden einer Mehrzahl von Eingangsspannungswerten, einzelnes Einstellen von einer Mehrzahl von Ausgangsleistungswerten;

b. Messen, für jede Kombination von Eingangsspannungswert und Ausgangsspannungswert, einer Eingangsleistung, $P_{in}$, zu der PFC-Stufe (104) und eines $T_{on}$ Werts;

c. Berechnen von Steigungen (m) und y-Achsenabschnitten (b) einer Mehrzahl von $P_{in}$ zu $t_{on}$ Kurven;

d. unter Verwendung der Steigungen, der y-Achsenabschnitte und $U_{in}$, Berechnen einer Mehrzahl von Steigungs-Konstanten Werten und einer Mehrzahl von y-Achsenabschnitts-Konstanten Werten, die jeweils der Mehrzahl von Steigungs-Konstanten und der Mehrzahl von y-Achsenabschnitts-Konstanten zugeordnet sind; und

e. Speichern der Mehrzahl von Steigungs-Konstanten Werten und der Mehrzahl von y-Achsenabschnitts-Konstanten Werten in dem Speicher (128).

15. Verfahren nach Anspruch 14, wobei der Eingangsleistungsschätzer (132) ferner auf die Betriebstemperatur kalibriert wird, und das Verfahren ferner umfasst:

Ausführen der Handlungen a. bis d. bei einer ersten Temperatur, um erste Steigungen und erste y-Achsenabschnitte zu erhalten;

Ausführen der Handlungen a. bis d. bei einer zweiten Temperatur, die sich von der ersten Temperatur unterscheidet, um zweite Steigungen und zweite y- Achsenabschnitte zu erhalten;

Bestimmen von differentiellen Steigungen zwischen den zweiten Steigungen und den ersten Steigungen und von differentiellen y-Achsenabschnitten zwischen den zweiten y-Achsenabschnitten und den ersten y-Achsenabschnitten;

Lösen eines Satzes von Differential-Gleichungen, die eine Funktion der Eingangsspannungswerte, eines Differentials zwischen der zweiten und der ersten Temperatur, der differentiellen Steigungen, der differentiellen y-Achsenabschnitte, einer Mehrzahl von Steigungs-Konstanten-Temperaturkompensations-Konstanten Werten und einer Mehrzahl von y-Achsenabschnitts-Konstanten-Temperaturkompensations-Konstanten Werten sind, um die Mehrzahl von Steigungs-Konstanten-Temperaturkompensations-Konstanten Werten und die Mehrzahl von y-Achsenabschnitts-Konstanten-Temperaturkompensations-Konstanten Werten zu bestimmen; und

Speichern der Mehrzahl von Steigungs-Konstanten-Temperaturkompensations-Konstanten Werten und der Mehrzahl von y-Achsenabschnitts-Konstanten-Temperaturkompensations-Konstanten Werten in dem Speicher (128).

**Revendications**

1. Procédé de mesure de l'énergie d'entrée dans un système, comprenant :

la prévision d'un estimateur d'énergie d'entrée (132) configuré de façon à résoudre une équation de pente-ordonnée à l'origine pour l'énergie d'entrée, $P_{in}$, cette équation de pente-ordonnée à l'origine étant une fonction d'un temps en circuit, $t_{on}$, d'un commutateur (116) commandé par un dispositif de commande de commutateur (120) et d'une tension d'entrée, $U_{in}$, entrés dans un étage de compensation de facteur de puissance (CFP) (104) du système et comprenant une pluralité de constantes de pentes (m1, m2, m3) et une pluralité de constantes d'ordonnées à l'origine (b1, b2, b3), qui sont déterminées à partir d'un développement linéaire de fonctions non linéaires (m($U_{in}$), b($U_{in}$)) de la tension d'entrée $U_{in}$, et l'étage CFP (104) comprenant le commutateur (116) ;
la réception d'une valeur de $t_{on}$ venant du dispositif de commande du commutateur (120) ;
la récupération, dans une mémoire (128), d'une pluralité de valeurs de constantes de pentes et d'une pluralité de valeurs de constantes d'ordonnées à l'origine, chargées dans la mémoire (128) pendant une procédure d'étalonnage de l'estimateur d'énergie d'entrée (132) ; et
la résolution de l'équation de pente-ordonnée à l'origine en utilisant la valeur de $t_{on}$, la tension d'entrée $U_{in}$, la pluralité de valeurs de constantes de pentes et la pluralité de valeurs de constantes d'ordonnées à l'origine afin de déterminer $P_{in}$.

2. Procédé selon la revendication 1, dans lequel l'équation de pente-ordonnée à l'origine comprend un développement en série de Taylor de chacune d'une équation non linéaire de pente et d'une équation non linéaire d'ordonnée à l'origine, chacune de l'équation non linéaire de pente et de l'équation non linéaire d'ordonnée à l'origine étant de préférence une fonction non linéaire de $U_{in}$.

3. Procédé selon la revendication 2, dans lequel l'équation de pente-ordonnée à l'origine est :

$$P_{\text{in,driver}} = \left(m_1 U_{\text{in,rms}}^2 + m_2 U_{\text{in,rms}} + m_3\right)t_{\text{on}} + \left(b_1 U_{\text{in,rms}}^2 + b_2 U_{\text{in,rms}} + b_3\right)$$

dans laquelle $m_1$, $m_2$, et $m_3$ sont la pluralité de valeurs de constantes de pentes et $b_1$, $b_2$, et $b_3$ sont la pluralité de valeurs de constantes d'ordonnées à l'origine.

4. Procédé selon l'une quelconque des revendications 1 à 3, dans lequel l'étage CFP (104) est une instanciation particulière et la pluralité de valeurs de constantes de pentes et la pluralité de valeurs de constantes d'ordonnées à l'origine sont des valeurs étalonnées qui sont étalonnées sur l'instanciation particulière.

5. Procédé selon l'une quelconque des revendications 1 à 4, dans lequel le dispositif de commande du commutateur (120) comprend une commande proportionnelle intégrale dérivée (PID), et la réception d'une valeur de $t_{on}$ venant du dispositif de commande du commutateur (120) comprend la réception de cette valeur de $t_{on}$ venant de la commande PID.

6. Procédé selon l'une quelconque des revendications 1 à 5, dans lequel l'équation de pente-ordonnée à l'origine est configurée en outre comme une fonction d'une différence de température, $\Delta T$, et comprend en outre :

une pluralité de valeurs de compensation de température de constantes de pentes correspondant respectivement à la pluralité de valeurs de constantes de pentes ; et
une pluralité de valeurs de compensation de température de constantes d'ordonnées à l'origine correspondant respectivement à la pluralité de valeurs de constantes d'ordonnées à l'origine ;
et ce procédé comprenant en outre :
la récupération d'une pluralité de valeurs constantes de compensation de température de constantes de pentes et une pluralité de valeurs constantes de compensation de température de constantes d'ordonnées à l'origine à partir de la mémoire (128) ;
le calcul de la pluralité de valeurs de compensation de température de constantes de pentes et de la pluralité de valeurs de compensation de température de constantes d'ordonnées à l'origine en utilisant, respectivement, la pluralité de valeurs constantes de compensation de température de constantes de pentes et la pluralité de valeurs constantes de compensation de température de constantes d'ordonnées à l'origine ; et
la résolution de l'équation de pente-ordonnée à l'origine en utilisant la valeur de $t_{on}$, la pluralité de valeurs de constantes de pentes, la pluralité de valeurs de constantes d'ordonnées à l'origine, la pluralité de valeurs constantes de compensation de température de constantes de pentes et la pluralité de valeurs constantes de compensation de température de constantes d'ordonnées à l'origine afin de déterminer $P_{in}$.

7. Procédé selon la revendication 6, comprenant en outre :

la réception d'une valeur de $\Delta T$ venant d'un estimateur de $\Delta T$ ; et
la multiplication de chacune de la pluralité de valeurs constantes de compensation de température de constantes de pentes et la pluralité de valeurs constantes de compensation de température de constantes d'ordonnées à l'origine par la valeur de $\Delta T$ afin de déterminer les valeurs respectives correspondantes de la pluralité de valeurs de compensation de température de constantes de pentes et de la pluralité de valeurs compensation de température de constantes d'ordonnées à l'origine,

ce procédé comprenant en outre de préférence l'addition de la pluralité de valeurs de compensation de température de constantes de pentes et de la pluralité de valeurs compensation de température de constantes d'ordonnées à l'origine aux valeurs respectives correspondantes de la pluralité de valeurs de constantes de pentes et de la pluralité de valeurs de constantes d'ordonnées à l'origine afin d'obtenir une pluralité de valeurs de constantes de pentes compensées en température et une pluralité de valeurs de constantes d'ordonnées à l'origine compensées en température destinées à être utilisées lors de l'étape de résolution au lieu de, respectivement, la pluralité de valeurs de constantes de pentes et la pluralité de valeurs de constantes d'ordonnées à l'origine.

8.  Dispositif comprenant :
    un système d'alimentation électrique qui comprend :

    un étage de compensation de facteur de puissance (CFP) comprenant un commutateur (116) et qui a, pendant son fonctionnement, une tension d'entrée, $U_{in}$ ;
    un dispositif de commande de commutateur (120) en communication avec le commutateur (116) et configuré de façon à fournir un signal de temps en circuit $t_{on}$, au commutateur (116) afin de commander le $t_{on}$ du commutateur (116) ;
    un estimateur d'énergie d'entrée (132) en communication fonctionnelle avec l'étage CFP (104) et le dispositif de commande du commutateur (120), cet estimateur d'énergie d'entrée (132) étant configuré de façon à résoudre une équation de pente-ordonnée à l'origine pour l'énergie d'entrée, $P_{in}$, entrée dans l'étage CFP (104), l'équation de pente-ordonnée à l'origine étant une fonction de $t_{on}$ et d' $U_{in}$, et comprenant une pluralité de constantes de pentes (m1, m2, m3) et une pluralité de constantes d'ordonnées à l'origine (b1, b2, b3), qui sont déterminées à partir d'un développement linéaire de fonctions non linéaires (m($U_{in}$), b($U_{in}$) ) de la tension d'entrée $U_{in}$ ; et une sortie pour communiquer $P_{in}$ en dehors de l'estimateur d'énergie d'entrée (132) ; et
    une mémoire (128) en communication fonctionnelle avec l'estimateur d'énergie d'entrée (132), cette mémoire (128) contenant une pluralité de valeurs de constantes de pentes et une pluralité de valeurs de constantes d'ordonnées à l'origine, chargées dans cette mémoire (128) pendant une procédure d'étalonnage, destinées à être utilisées par l'estimateur d'énergie d'entrée (132) pour résoudre l'équation de pente-ordonnée à l'origine pour $P_{in}$.

9.  Dispositif selon la revendication 8, dans lequel l'équation de pente-ordonnée à l'origine comprend un développement en série de Taylor de chacune d'une équation non linéaire de pente et d'une équation non linéaire d'ordonnée à l'origine, chacune de l'équation non linéaire de pente et de l'équation non linéaire d'ordonnée à l'origine étant de préférence une fonction non linéaire de $U_{in}$.

10. Dispositif selon la revendication 9, dans lequel la récupération d'une pluralité de valeurs de constantes de pentes et d'une pluralité de valeurs de constantes d'ordonnées à l'origine comprend la récupération de trois valeurs de constantes de pentes et de trois valeurs de constantes d'ordonnées à l'origine,
    l'équation de pente-ordonnée à l'origine étant de préférence :

$$P_{\text{in,driver}} = \left(m_1 U_{\text{in,rms}}^2 + m_2 U_{\text{in,rms}} + m_3\right)t_{\text{on}} + \left(b_1 U_{\text{in,rms}}^2 + b_2 U_{\text{in,rms}} + b_3\right)$$

dans laquelle $m_1$, $m_2$, et $m_3$ sont la pluralité de valeurs de constantes de pentes et $b_1$, $b_2$, et $b_3$ sont la pluralité de valeurs de constantes d'ordonnées à l'origine.

11. Dispositif selon l'une quelconque des revendications 8 à 10, dans lequel l'étage CFP (104) est une instanciation particulière et la pluralité de valeurs de constantes de pentes et la pluralité de valeurs de constantes d'ordonnées à l'origine sont des valeurs étalonnées qui sont étalonnées sur l'instanciation particulière.

12. Dispositif selon l'une quelconque des revendications 8 à 11, dans lequel l'équation de pente-ordonnée à l'origine est configurée en outre comme une fonction d'une différence de température, $\Delta T$, et comprend en outre :

    une pluralité de valeurs de compensation de température de constantes de pentes correspondant respectivement à la pluralité de constantes de pentes ; et
    une pluralité de valeurs de compensation de température de constantes d'ordonnées à l'origine correspondant

respectivement à la pluralité de constantes d'ordonnées à l'origine ; et

la mémoire (128) contenant une pluralité de valeurs constantes de compensation de température de constantes de pentes et une pluralité de valeurs constantes de compensation de température de constantes d'ordonnées à l'origine.

13. Procédé selon la revendication 12, comprenant en outre :

un estimateur de $\Delta T$ configuré de façon à générer la valeur $\Delta T$ ; et

un compensateur de température configuré de façon à multiplier chacune de la pluralité de valeurs constantes de compensation de température de constantes de pentes et la pluralité de valeurs constantes de compensation de température de constantes d'ordonnées à l'origine par la valeur de $\Delta T$ afin de déterminer les valeurs respectives correspondantes de la pluralité de valeurs de compensation de température de constantes de pentes et de la pluralité de valeurs compensation de température de constantes d'ordonnées à l'origine, l'estimateur d'énergie d'entrée (132) étant en outre configuré de préférence de façon à additionner la pluralité de valeurs de compensation de température de constantes de pentes et la pluralité de valeurs compensation de température de constantes d'ordonnées à l'origine aux valeurs respectives correspondantes de la pluralité de valeurs de constantes de pentes et de la pluralité de valeurs de constantes d'ordonnées à l'origine afin d'obtenir une pluralité de valeurs de constantes de pentes compensées en température et une pluralité de valeurs de constantes d'ordonnées à l'origine compensées en température destinées à être utilisées lors de l'étape de résolution au lieu de, respectivement, la pluralité de valeurs de constantes de pentes et la pluralité de valeurs de constantes d'ordonnées à l'origine.

14. Procédé d'étalonnage d'un estimateur d'énergie d'entrée (132) d'un système d'alimentation électrique dans un dispositif selon la revendication 8, ce procédé comprenant :

a. pour chacune d'une pluralité de valeurs de tension d'entrée, l'établissement, consécutivement, d'une pluralité de valeurs d'énergie de sortie ;

b. la mesure, pour chaque combinaison de valeur de tension d'entrée et de valeur de tension de sortie, d'une énergie d'entrée, $P_{in}$, dans l'étage CFP (104) et d'une valeur de $t_{on}$;

c. le calcul de pentes (m) et d'ordonnées à l'origine (b) d'une pluralité de courbes de $P_{in}$ en fonction de $t_{on}$;

d. en utilisant les pentes, les ordonnées à l'origine et $U_{in}$, le calcul d'une pluralité de valeurs de constantes de pentes et d'une pluralité de valeurs de constantes d'ordonnées à l'origine correspondant, respectivement, à la pluralité de constantes de pentes et à la pluralité de constantes d'ordonnées à l'origine ; et

e. le stockage de la pluralité de valeurs de constantes de pentes et de pluralité de valeurs de constantes d'ordonnées à l'origine dans la mémoire (128) .

15. Procédé selon la revendication 14, dans lequel l'estimateur d'énergie d'entrée (132) est étalonné en outre pour la température de fonctionnement, ce procédé comprenant en outre :

l'exécution des actions a. jusqu'à d. à une première température afin d'obtenir des premières pentes et des premières ordonnées à l'origine ;

l'exécution des actions a. jusqu'à d. à une deuxième température différente de la première température afin d'obtenir des deuxièmes pentes et des deuxièmes ordonnées à l'origine ;

la détermination de pentes différentielles entre les deuxièmes pentes et les premières pentes et d'ordonnées à l'origine différentielles entre les deuxièmes ordonnées à l'origine et les premières ordonnées à l'origine ;

la résolution d'un ensemble d'équations différentielles qui sont une fonction des premières valeurs de tension d'entrée, d'une différence entre la deuxième et la première température, des pentes différentielles, des ordonnées à l'origine différentielles, d'une pluralité de valeurs constantes de compensation de température de constantes de pentes, d'une pluralité de valeurs constantes de compensation de température de constantes d'ordonnées à l'origine afin de déterminer la pluralité de valeurs constantes compensation de température de constantes de pentes et la pluralité de valeurs constantes compensation de température de constantes d'ordonnées à l'origine ; et

le stockage de la pluralité de valeurs constantes de compensation de température de constantes de pentes et de la pluralité de valeurs constantes de compensation de température de constantes d'ordonnées à l'origine dans la mémoire (128).

INPUT 108

PFC STAGE 104

ELEC. PWR.
SYSTEM 100

SWITCH 116

OUTPUT 112

SWITCH CONTROLLER 120

SWITCH CONTROL
ALG. 124

TEMP. ESTIMATOR 156

INPUT-POWER
ESTIMATOR 132

SLOPE-INTERCEPT
EQUATION 136

OUTPUT DEVICE 160

TEMP. DIFFERENTIAL 152

TEMP. COMPENSATOR 144

STORAGE MEMORY 128

VALUES 140A

VALUES 148A

VALUES 140B

VALUES 148B

VALUES 140

VALUES 148

FIG. 1

ELEC. PWR.
SYS. 200(1)

PWR. DATA
208(1)

HIGH-LEVEL
SYSTEM 204

ELEC. DEVICE
212(1)

PWR. DATA
208(2)

PWR. DATA
208(1)

ELEC. DEVICE
212(2)

ELEC. PWR.
SYS. 200(2)

NETWORK(S) 216

ELEC. DEVICE
212(N)

PWR. DATA
208(N)

PWR. DATA
208(2)

PWR. DATA
208(N)

ELEC. PWR.
SYS. 200(N)

FIG. 2

FIG. 3

FIG. 4

FIG. 5

FIG. 6

FIG. 7

**EP 3 605 815 B1**

**Patent documents cited in the description**

- US 2016190912 A1
- US 2008315852 A1
- CN 101764528 A
- US 2010246220 A1
- US 2014239741 A1